# EUROPEAN PATENT APPLICATION

(11) **EP 4 131 221 A1**
(43) Date of publication of application: **08.02.2023**
(21) Application number: 21781407.8
(22) Date of filing: 31.03.2021
(51) Int. Cl.: G09F 9/30, H01L 27/32, H05B 33/04, H05B 33/06, H05B 33/12, H01L 51/50, H05B 33/26

(54) **DISPLAY DEVICE AND ELECTRONIC APPARATUS**

(30) Priority: 31.03.2020 JP 2020062823
(71) Applicant: Sony Group Corporation, Tokyo 108-0075 (JP); Sony Semiconductor Solutions Corporation, Atsugi-shi Kanagawa 243-0014 (JP)
(72) Inventor: UCHIDA, Masashi, Tokyo 108-0075 (JP); KATO, Yu, Atsugi-shi, Kanagawa 243-0014 (JP); KASAHARA, Naoya, Tokyo 108-0075 (JP); YAMAZAKI, Takashi, Atsugi-shi, Kanagawa 243-0014 (JP); OHCHI, Tomokazu, Atsugi-shi, Kanagawa 243-0014 (JP)
(74) Representative: D Young & Co LLP
(86) International application number: PCT/JP2021/013957
(87) International publication number: WO 2021/201144

(57) **Abstract**

A display device includes an anode electrode, an organic light emitting layer, and a first cathode electrode. Provided are a plurality of light emitting elements in which the anode electrode, the organic light emitting layer, and the first cathode are separated for each sub-pixel, a protective layer covering the plurality of light emitting elements, and a second cathode electrode provided on the protective layer. The second cathode electrode is connected to each separated first cathode electrode.

## Description

### TECHNICAL FIELD

The present disclosure relates to a display device and an electronic apparatus including the display device.

### BACKGROUND ART

In recent years, a display device using an organic electro-luminescence (EL) element has been developed. A display device using an organic EL element has a structure in which an organic layer including at least an organic light emitting layer and a second electrode are stacked on a first electrode formed separately for each pixel. One pixel is configured by a plurality of sub-pixels such as R, G, and B.

Patent Document 1 proposes an organic light emitting device in which an upper electrode is configured by a first upper electrode and a second upper electrode directly provided on the first upper electrode.

### CITATION LIST

### PATENT DOCUMENT

Patent Document 1: Japanese Patent Application Laid-Open No. 2016 021380

### SUMMARY OF THE INVENTION

### PROBLEMS TO BE SOLVED BY THE INVENTION

However, in the organic light emitting device described in Patent Document 1, the organic light emitting layer is exposed to a process gas, a chemical liquid, or the like in a patterning process of the first upper electrode or the second upper electrode, and is damaged and deteriorated. For this reason, the organic light emitting device described in Patent Document 1 has a problem that reliability is deteriorated.

An object of the present disclosure is to provide a display device capable of suppressing a decrease in reliability and an electronic apparatus including the display device.

### SOLUTIONS TO PROBLEMS

In order to solve the above-described problems, a first disclosure is a display device including: a plurality of light emitting elements including an anode electrode, an organic light emitting layer, and a first cathode electrode, the anode electrode, the organic light emitting layer, and the first cathode electrode being separated for each sub-pixel; a protective layer configured to cover the plurality of light emitting elements; and a second cathode electrode provided on the protective layer. The second cathode electrode is connected to each of the separated first cathode electrodes.

A second disclosure is a display device including: a plurality of light emitting elements including a first electrode, an organic light emitting layer, and a second electrode, the second electrode, the organic light emitting layer, and the second electrode being separated for each sub-pixel; a protective layer configured to cover the plurality of light emitting elements; and a third electrode provided on the protective layer. The third electrode is connected to each of the separated second electrodes.

A third disclosure is an electronic apparatus including a display device of the first disclosure or the second disclosure.

The protective layer may have a plurality of contact holes, and the second cathode electrode may be configured to be connected to each of the separated first cathode electrodes via the contact hole.

The shape of the sub-pixel may be substantially elliptical, substantially hexagonal, substantially square, or substantially rectangular.

The plurality of light emitting elements may include a plurality of first light emitting elements configured to be able to emit red light, a plurality of second light emitting elements configured to be able to emit green light, and a plurality of third light emitting elements configured to be able to emit blue light.

The plurality of light emitting elements may be configured to be able to emit white light.

The first cathode electrode and the second cathode electrode may each independently contain a transparent metal oxide, metal, or alloy. The metal oxide may contain at least one selected from the group consisting of indium-zinc oxide (IZO), indium-tin oxide (ITO), zinc oxide (ZnO), tin oxide (SnO), aluminum-zinc oxide (AZO), and gallium-zinc oxide (GZO). The metal may contain at least one selected from the group consisting of aluminum (Al), silver (Ag), magnesium (Mg), calcium (Ca), sodium (Na), and strontium (Sr). The alloy may include at least one selected from the group consisting of an alloy of an alkali metal or an alkaline earth metal and silver (Ag), an alloy of magnesium (Mg) and silver (Ag), an alloy of magnesium (Mg) and calcium (Ca), and an alloy of aluminum (Al) and lithium (Li).

The first cathode electrode may include a transparent metal oxide, and the second cathode electrode may include a metal or an alloy. In this case, the resonator structure may be configured for each sub-pixel by the anode electrode and the second cathode electrode.

The first cathode electrode may contain a metal or an alloy, and the second cathode electrode may contain a transparent metal oxide. In this case, the resonator structure may be configured for each sub-pixel by the anode electrode and the first cathode electrode.

The protective layer may contain at least one of an inorganic oxide and an organic insulating material. The inorganic oxide may contain, for example, at least one selected from the group consisting of silicon nitride (SiN), silicon oxide (SiO), silicon oxynitride (SiON), aluminum oxide (AlO), and titanium oxide (TiO).

The protective layer may be a single layer film or a multilayer film. The multilayer film may include first to n-th layers. The first to n-th layers may contain different materials from one another, for example different inorganic oxides or organic insulating materials from one another.

A plurality of the sub-pixels may include a plurality of red sub-pixels, a plurality of green sub-pixels, and a plurality of blue sub-pixels, and a thickness of the protective layer on the separated first cathode electrode may be substantially a same in the red sub-pixel, the green sub-pixel, and the blue sub-pixel.

The sub-pixel may be provided with a resonator structure that causes light generated in the organic light emitting layer to resonate. A plurality of the sub-pixels may include a plurality of red sub-pixels, a plurality of green sub-pixels, and a plurality of blue sub-pixels. A thickness of the protective layer on the separated first cathode electrode may be different for each of the red sub-pixel, the green sub-pixel, and the blue sub-pixel. In this case, the resonator structure may be configured by the anode electrode and the second cathode electrode.

The first cathode electrode and the second cathode electrode may be connected outside a light emitting region of the sub-pixel.

The number of connecting portions between the first cathode electrode and the second cathode electrode may be one or two or more for one sub-pixel. From the viewpoint of improving conductivity between the first cathode electrode and the second cathode electrode, the number of connecting portions between the first cathode electrode and the second cathode electrode is preferably two or more for one sub-pixel.

The second cathode electrode may include a plurality of contact portions, and one of the contact portions may be connected to two or more of the sub-pixels.

A connecting portion between the first cathode electrode and the second cathode electrode may have a dotted or linear shape. Here, the dotted or linear shape is a shape in a case where the connecting portion is viewed in a plan view from a direction perpendicular to the display surface of the display device. The dotted connecting portion may be substantially triangular, substantially quadrangular, substantially circular, substantially hexagonal, substantially octagonal, or linear.

The first cathode electrode may have a facing surface that faces the second anode electrode, and the linear connecting portion may be provided along a peripheral edge of the facing surface.

The second cathode electrode may be connected to an end portion of the first cathode electrode.

The first cathode electrode may have a protruding portion that protrudes with respect to a peripheral edge of the light emitting region of the light emitting element, and the second cathode electrode may be connected to the first cathode electrode at the protruding portion.

The light emitting element may have a cutout portion at a peripheral edge of a light emitting region of the light emitting element, and the second cathode electrode may be connected to the first cathode electrode in the cutout portion.

The protective layer may have a plurality of air gaps, and each of the plurality of these air gaps may be provided between the sub-pixels that are adjacent to each other.

The display device may further include: a protective layer configured to cover the second cathode electrode.

The display device may further include a color filter provided to face the plurality of light emitting elements, or may further include an on-chip color filter provided on the plurality of light emitting elements.

The first electrode may be an anode electrode, and the second electrode and the third electrode may be a first cathode electrode and a second cathode electrode, respectively, or the first electrode may be a cathode electrode, and the second electrode and the third electrode may be a first anode electrode and a second anode electrode, respectively.

### BRIEF DESCRIPTION OF DRAWINGS

Fig. 1 is a plan view illustrating an example of an overall configuration of a display device according to a first embodiment of the present disclosure.
Fig. 2 is a cross-sectional view illustrating an example of a configuration of a display device according to the first embodiment of the present disclosure.
Fig. 3A is a plan view illustrating a shape example of a sub-pixel.
Fig. 3B is a plan view illustrating a shape example of the sub-pixel.
Fig. 3C is a plan view illustrating a shape example of the sub-pixel.
Fig. 3D is a plan view illustrating a shape example of the sub-pixel.
Fig. 4 is a cross-sectional view taken along line IV-IV of Fig. 3A.
Fig. 5 is an enlarged cross-sectional view illustrating the organic layer illustrated in Fig. 2.
Fig. 6 is a cross-sectional view illustrating a modification of the protective layer.
Fig. 7A is a process diagram for explaining an example of a method of manufacturing the display device according to the first embodiment of the present disclosure.
Fig. 7B is a process diagram for explaining an example of the method of manufacturing the display device according to the first embodiment of the present disclosure.
Fig. 7C is a process diagram for explaining an example of the method of manufacturing the display device according to the first embodiment of the present disclosure.
Fig. 7D is a process diagram for explaining an example of the method of manufacturing the display device according to the first embodiment of the present disclosure.
Fig. 7E is a process diagram for explaining an example of the method of manufacturing the display device according to the first embodiment of the present disclosure.
Fig. 8A is a cross-sectional view illustrating a modification of the display device.
Fig. 8B is a cross-sectional view illustrating a modification of the display device.
Fig. 9A is a cross-sectional view illustrating a modification of the display device.
Fig. 9B is a cross-sectional view illustrating a modification of the display device.
Fig. 10A is a cross-sectional view illustrating a modification of the display device.
Fig. 10B is a cross-sectional view illustrating a modification of the display device.
Fig. 11A is a plan view illustrating a modification of the sub-pixel.
Fig. 11B is a plan view illustrating a modification of the sub-pixel.
Fig. 11C is a plan view illustrating a modification of the sub-pixel.
Fig. 12 is a cross-sectional view taken along line XII-XII of Fig. 11A.
Fig. 13A is a plan view illustrating a modification of a connecting portion.
Fig. 13B is a plan view illustrating a modification of the connecting portion.
Fig. 13C is a plan view illustrating a modification of the connecting portion.
Fig. 13D is a plan view illustrating a modification of the connecting portion.
Fig. 14 is a plan view illustrating a shape example of the connecting portion.
Fig. 15 is a cross-sectional view illustrating a modification of the display device.
Fig. 16A is a plan view illustrating a modification of the connecting portion.
Fig. 16B is a plan view illustrating a modification of the connecting portion.
Fig. 16C is a plan view illustrating a modification of the connecting portion.
Fig. 16D is a plan view illustrating a modification of the connecting portion.
Fig. 17A is a plan view illustrating a modification of the connecting portion.
Fig. 17B is a plan view illustrating a modification of the connecting portion.
Fig. 17C is a plan view illustrating a modification of the connecting portion.
Fig. 18A is a plan view illustrating a modification of the connecting portion.
Fig. 18B is a plan view illustrating a modification of the connecting portion.
Fig. 19 is a cross-sectional view illustrating a modification of the display device.
Fig. 20A is a plan view illustrating a modification of the connecting portion.
Fig. 20B is a plan view illustrating a modification of the connecting portion.
Fig. 20C is a plan view illustrating a modification of the connecting portion.
Fig. 20D is a plan view illustrating a modification of the connecting portion.
Fig. 21 is a cross-sectional view illustrating a modification of the display device.
Fig. 22A is a plan view illustrating a modification of the connecting portion.
Fig. 22B is a plan view illustrating a modification of the connecting portion.
Fig. 22C is a plan view illustrating a modification of the connecting portion.
Fig. 23 is a cross-sectional view illustrating a modification of the display device.
Fig. 24 is a cross-sectional view illustrating a modification of the display device.
Fig. 25 is a plan view illustrating an example of a schematic configuration of a module.
Fig. 26A is a front view illustrating an example of an external appearance of a digital still camera.
Fig. 26B is a rear view illustrating an example of an external appearance of the digital still camera.
Fig. 27 is a perspective view of an example of an external appearance of a head mounted display.
Fig. 28 is a perspective view illustrating an example of an external appearance of a television device.
Fig. 29A is a process diagram for explaining an example of a method of manufacturing a display device according to a second embodiment of the present disclosure.
Fig. 29B is a process diagram for explaining an example of the method of manufacturing the display device according to the second embodiment of the present disclosure.
Fig. 29C is a process diagram for explaining an example of the method of manufacturing the display device according to the second embodiment of the present disclosure.
Fig. 29D is a process diagram for explaining an example of the method of manufacturing the display device according to the second embodiment of the present disclosure.
Fig. 29E is a cross-sectional view illustrating an example of a configuration of a display device according to a third embodiment of the present disclosure.
Fig. 30A is a process diagram for explaining an example of a method of manufacturing a display device according to a modification.
Fig. 30B is a process diagram for explaining an example of the method of manufacturing the display device according to the modification.
Fig. 30C is a process diagram for explaining an example of the method of manufacturing the display device according to the modification.
Fig. 30D is a process diagram for explaining an example of the method of manufacturing the display device according to the modification.
Fig. 30E is a process diagram for explaining an example of the method of manufacturing the display device according to the modification.
Fig. 30F is a cross-sectional view illustrating an example of a configuration of the display device according to the modification.
Fig. 31A is a process diagram for explaining an example of a method of manufacturing a display device according to a modification.
Fig. 31B is a process diagram for explaining an example of the method of manufacturing the display device according to the modification.
Fig. 31C is a process diagram for explaining an example of the method of manufacturing the display device according to the modification.
Fig. 31D is a process diagram for explaining an example of the method of manufacturing the display device according to the modification.
Fig. 31E is a process diagram for explaining an example of the method of manufacturing the display device according to the modification.
Fig. 31F is a process diagram for explaining an example of the method of manufacturing the display device according to the modification.
Fig. 31G is a cross-sectional view illustrating an example of a configuration of the display device according to the modification.
Fig. 32A is a process diagram for explaining an example of a method of manufacturing a display device according to a modification.
Fig. 32B is a process diagram for explaining an example of the method of manufacturing the display device according to the modification.
Fig. 32C is a process diagram for explaining an example of the method of manufacturing the display device according to the modification.
Fig. 32D is a cross-sectional view illustrating an example of a configuration of the display device according to the modification.
Fig. 33A is a process diagram for explaining an example of a method of manufacturing a display device according to a modification.
Fig. 33B is a cross-sectional view illustrating an example of a configuration of the display device according to the modification.
Fig. 34A is a cross-sectional view illustrating an example of a configuration of a display device according to a modification.
Fig. 34B is a cross-sectional view illustrating an example of a configuration of a display device according to a modification.
Fig. 35A is a cross-sectional view illustrating an example of a configuration of a display device according to a modification.
Fig. 35B is a cross-sectional view illustrating an example of a configuration of a display device according to a modification.
Fig. 35C is a cross-sectional view illustrating an example of a configuration of a display device according to a modification.
Fig. 36A is a process diagram for explaining an example of a method of manufacturing a display device according to a modification.
Fig. 36B is a process diagram for explaining an example of the method of manufacturing the display device according to the modification.
Fig. 36C is a cross-sectional view illustrating an example of a configuration of the display device according to the modification.
Fig. 37A is a cross-sectional view illustrating an example of a configuration of a display device according to a modification.
Fig. 37B is a cross-sectional view illustrating an example of the configuration of the display device according to the modification.
Fig. 38 is a cross-sectional view illustrating an example of a configuration of a display device according to a modification.
Fig. 39 is a cross-sectional view illustrating an example of a configuration of the display device according to the third embodiment of the present disclosure.
Fig. 40A is a plan view illustrating a shape example of a sub-pixel.
Fig. 40B is a plan view illustrating a shape example of the sub-pixel.
Fig. 40C is a plan view illustrating a shape example of the sub-pixel.
Fig. 41A is a plan view illustrating a shape example of the sub-pixel.
Fig. 41B is a plan view illustrating a shape example of the sub-pixel.
Fig. 41C is a plan view illustrating a shape example of the sub-pixel.
Fig. 42A is a process diagram for explaining an example of a method of manufacturing the display device according to the third embodiment of the present disclosure.
Fig. 42B is a process diagram for explaining an example of the method of manufacturing the display device according to the third embodiment of the present disclosure.
Fig. 42C is a process diagram for explaining an example of the method of manufacturing the display device according to the third embodiment of the present disclosure.
Fig. 42D is a process diagram for explaining an example of the method of manufacturing the display device according to the third embodiment of the present disclosure.
Fig. 42E is a process diagram for explaining an example of the method of manufacturing the display device according to the third embodiment of the present disclosure.
Fig. 42F is a process diagram for explaining an example of the method of manufacturing the display device according to the third embodiment of the present disclosure.
Fig. 43A is a cross-sectional view illustrating an example of a configuration of a display device according to a modification.
Fig. 43B is a cross-sectional view illustrating an example of a configuration of a display device according to a modification.

### MODE FOR CARRYING OUT THE INVENTION

Embodiments of the present disclosure will be described in the following order. Note that, in all the drawings of the following embodiments, the same or corresponding parts are denoted by the same reference numerals.
1 First embodiment
   1.1 Configuration of display device
   1.2 Method of manufacturing display device
   1.3 Operational effect
   1.4 Modifications
2 Second embodiment
   2.1 Configuration of display device
   2.2 Method of manufacturing display device
   2.3 Operational effect
   2.4 Modifications
3 Third embodiment
   3.1 Configuration of display device
   3.2 Method of manufacturing display device
   3.3 Operational effect
   3.4 Modifications
4 Applications

### < 1 First embodiment >

### [1.1 Configuration of display device]

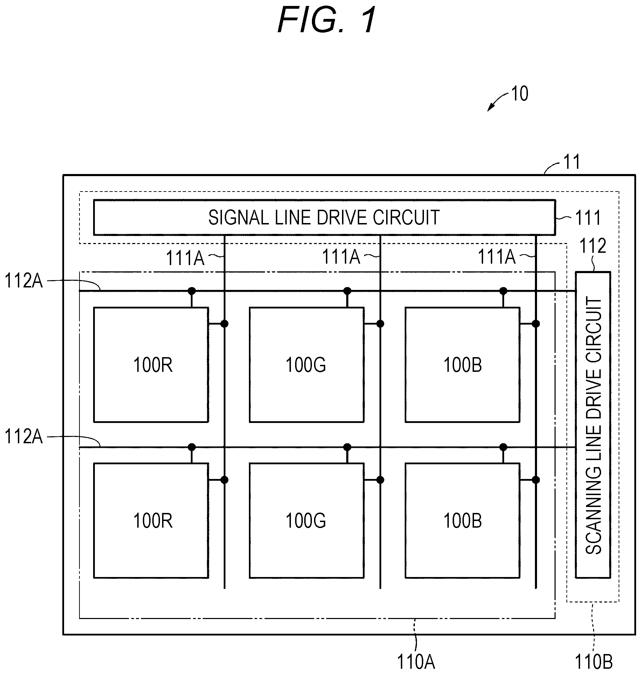

Fig. 1 is a plan view illustrating an example of an overall configuration of an organic EL display device 10 (hereinafter, simply referred to as "display device 10") according to a first embodiment of the present disclosure. The display device 10 is suitable for use in various electronic apparatuses, and a display region 110A and a peripheral region 110B are provided on a substrate 11 at the peripheral edge of the display region 110A. In the display region 110A, a plurality of sub-pixels (sub-pixels) 100R, 100G, and 100B is arranged in a matrix. The sub-pixel 100R displays red, the sub-pixel 100G displays green, and the sub-pixel 100B displays blue. Note that, in the following description, the red, green, and blue sub-pixels 100R, 100G, and 100B will be referred to as the sub-pixels 100 unless otherwise distinguished.

In the peripheral region 110B, a signal line drive circuit 111 and a scanning line drive circuit 112, which are drivers for image display, are provided. The signal line drive circuit 111 supplies a signal voltage of an image signal corresponding to luminance information supplied from a signal supply source (not illustrated) to the sub-pixel 100 selected via a signal line 111A. The scanning line drive circuit 112 has a configuration by a shift register and the like that sequentially shifts (transfers) a start pulse in synchronization with an input clock pulse. The scanning line drive circuit 112 scans the sub-pixels 100 row by row at the time of writing the image signal to each sub-pixel, and sequentially supplies a scanning signal to scanning lines 112A.

The display device 10 is, for example, a microdisplay in which self-emitting elements such as an OLED, a Micro-OLED, or a Micro-LED are formed in an array. The display device 10 is suitably used for a display device for virtual reality (VR), mixed reality (MR), or augmented reality (AR), an electronic viewfinder (EVF), a small projector, or the like.

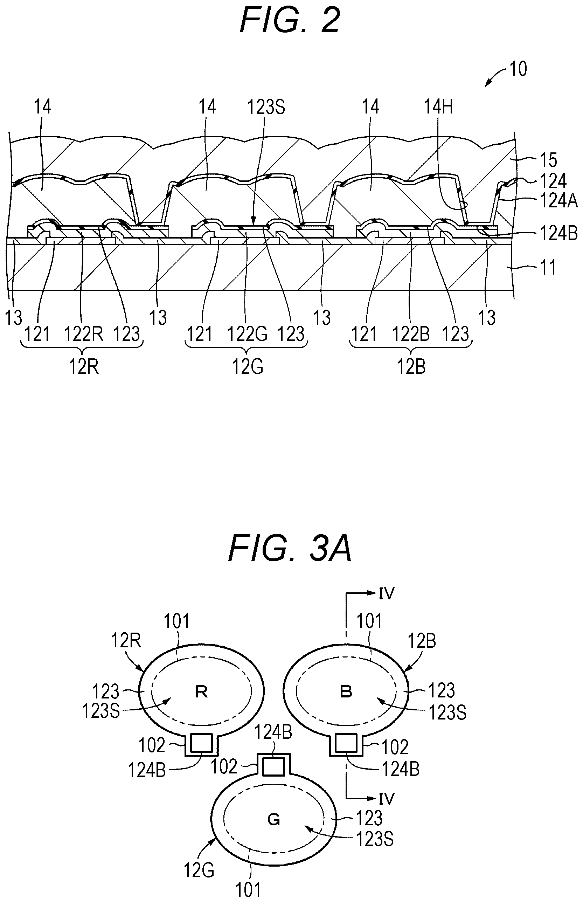

Fig. 2 is a cross-sectional view illustrating an example of a configuration of the display device 10 according to the first embodiment of the present disclosure. The display device 10 is a top emission type display device, and includes the substrate 11 having one main surface, a plurality of light emitting elements (first light emitting elements) 12R, a plurality of light emitting elements (second light emitting elements) 12G, a plurality of light emitting elements (third light emitting elements) 12B, and an insulating layer 13 provided on the one main surface of the substrate 11, a protective layer 14 covering the plurality of light emitting elements 12R, the plurality of light emitting elements 12G, and the plurality of light emitting elements 12B, a second cathode electrode 124 provided on the protective layer 14, and a protective layer 15 covering the second cathode electrode 124. The display device 10 may further include a filling resin layer (not illustrated) provided on the protective layer 15 and a counter substrate (not illustrated) provided on the filling resin layer as necessary. Note that the protective layer 15 side is the top side, and the substrate 11 side is the bottom side. Note that, in the following description, the light emitting elements 12R, 12G, and 12B will be referred to as light emitting elements 12 unless otherwise distinguished.

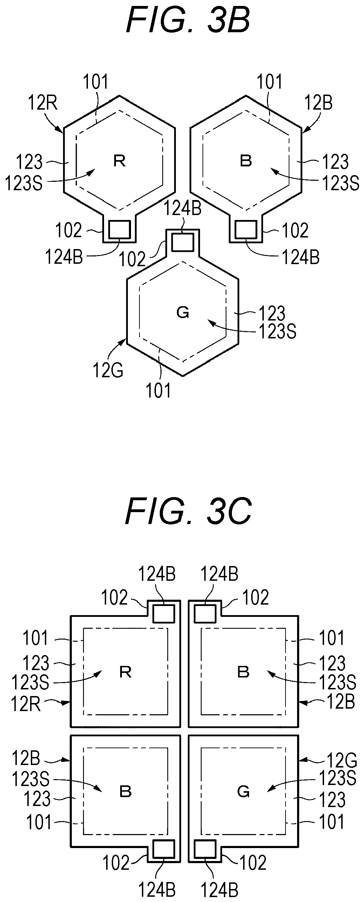

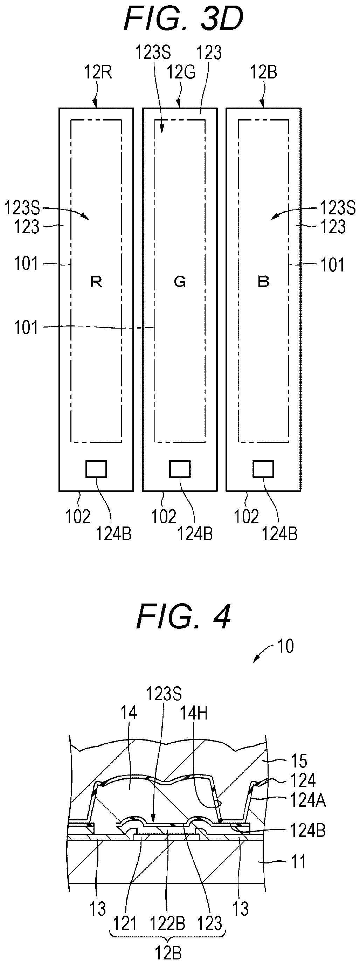

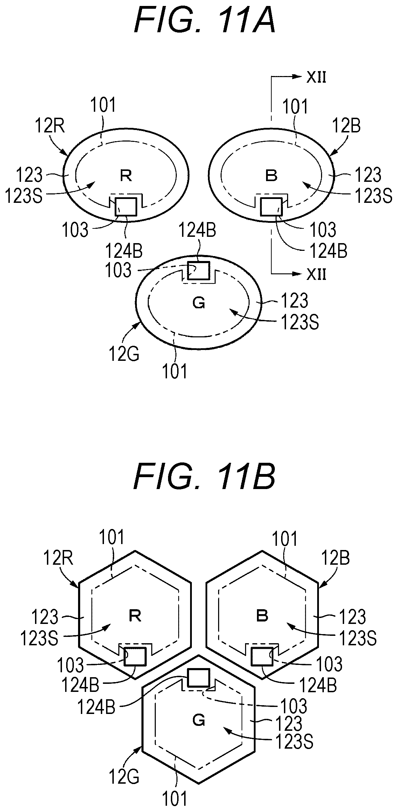

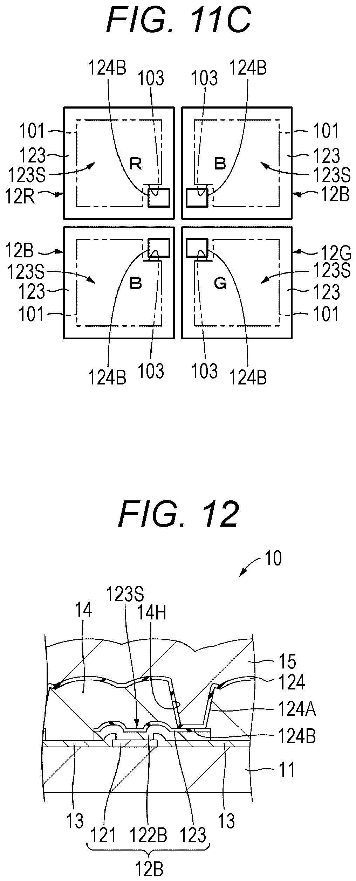

Figs. 3A, 3B, 3C, and 3D are plan views illustrating shape examples of the sub-pixel 100, respectively. In the first embodiment, each of the sub-pixels 100R, 100G, and 100B is configured by the light emitting element 12R, the light emitting element 12G, and the light emitting element 12B. The shape of the sub-pixel 100 is, for example, a substantially elliptical shape (see Fig. 3A), a substantially hexagonal shape (see Fig. 3B), a substantially square shape (see Fig. 3C), a substantially rectangular shape (see Fig. 3D), or the like. Two or more shapes may be used in combination. In the present specification, a rectangle means a quadrangle having two long sides and two short sides and having four interior angles at right angles. That is, the square is excluded from the rectangle. Furthermore, the substantially elliptical shape, the substantially hexagonal shape, the substantially square shape, the substantially rectangular shape, and the like include a shape in which a part of a peripheral edge of an elliptical shape, a hexagonal shape, a square shape, a rectangular shape, and the like protrudes (see Figs. 3A, 3B, 3C, 3D, and the like), and a shape in which a part of a peripheral edge of an elliptical shape, a hexagonal shape, a square shape, a rectangular shape, and the like is cut out (see Fig. 11A, Fig. 11B, Fig. 11C, and the like). Note that Fig. 1 illustrates an example in which the sub-pixel 100 is substantially square.

The sub-pixels 100 are two-dimensionally arranged in a prescribed pattern. For example, the plurality of sub-pixels 100 having a substantially elliptical shape may be arranged in a staggered manner such that the major axis directions of the respective sub-pixels 100 are aligned (see Fig. 3A). The plurality of sub-pixels 100 having a substantially hexagonal shape may be arranged in a honeycomb shape (see Fig. 3B). The plurality of sub-pixels 100 having a substantially square shape may be arranged in a matrix (see Fig. 3C). The plurality of sub-pixels 100 having a substantially rectangular shape may be arranged in a stripe shape (see Fig. 3D). The sub-pixels 100R, 100G, and 100B may be repeatedly arranged in the row direction. One pixel (pixel) is configured by a combination of three adjacent sub-pixels 100R, 100G, and 100B.

The sub-pixel 100, that is, the light emitting element 12 has a light emitting region 101. The light emitting region 101 may have a shape similar to that of the sub-pixel 100. That is, each of the sub-pixels 100 having a substantially elliptical shape, a substantially hexagonal shape, a substantially square shape, and a substantially rectangular shape may have the light emitting region 101 having a substantially elliptical shape, a substantially hexagonal shape, a substantially square shape, and a substantially rectangular shape.

### (Light emitting element)

The plurality of light emitting elements 12 is two-dimensionally arranged in a prescribed pattern on one main surface of the substrate 11. The plurality of light emitting elements 12 includes a plurality of light emitting elements 12R, a plurality of light emitting elements 12G, and a plurality of light emitting elements 12B. The light emitting element 12R is a red OLED configured to emit red light. The light emitting element 12G is a green OLED configured to emit green light. The light emitting element 12B is a blue OLED configured to emit blue light. The light emitting element 12 may be a MOLED (Micro-OLED) or a Micro-LED.

The light emitting element 12R includes an anode electrode 121 provided on the substrate 11, an organic layer 122R provided on the anode electrode 121, and a first cathode electrode 123 provided on the organic layer 122R. The light emitting element 12G includes the anode electrode 121 provided on the substrate 11, an organic layer 122G provided on the anode electrode 121, and the first cathode electrode 123 provided on the organic layer 122G. The light emitting element 12B includes the anode electrode 121 provided on the substrate 11, an organic layer 122B provided on the anode electrode 121, and the first cathode electrode 123 provided on the organic layer 122B. Note that, in the following description, the organic layers 122R, 122G, and 122B are referred to as an organic layer 122 unless otherwise distinguished.

### (Substrate)

The substrate 11 is a support that supports the plurality of light emitting elements 12 arranged on one main surface. Furthermore, although not illustrated, the substrate 11 may be provided with a drive circuit including a sampling transistor and a driving transistor for controlling driving of the plurality of light emitting elements 12, a power source circuit for supplying power to the plurality of light emitting elements 12, and the like.

The substrate 11 may include, for example, glass or resin having low permeability for moisture and oxygen, or may include a semiconductor easily formed with a transistor and the like. Specifically, the substrate 11 may be a glass substrate such as high strain point glass, soda glass, borosilicate glass, forsterite, lead glass, or quartz glass, a semiconductor substrate such as amorphous silicon or polycrystalline silicon, a resin substrate such as polymethyl methacrylate, polyvinyl alcohol, polyvinyl phenol, polyether sulfone, polyimide, polycarbonate, polyethylene terephthalate, or polyethylene naphthalate, or the like.

### (Anode electrode)

The anode electrode 121 is electrically separated for each of the sub-pixels 100R, 100G, and 100B. The anode electrode 121 also has a function as a reflection layer, and is preferably configured by a metal layer having as high a reflectance as possible and a large work function in order to enhance light emission efficiency. The metal layer contains, for example, at least one of a simple substance and an alloy of metal elements such as chromium (Cr), gold (Au), platinum (Pt), nickel (Ni), copper (Cu), molybdenum (Mo), titanium (Ti), tantalum (Ta), aluminum (Al), magnesium (Mg), iron (Fe), tungsten (W), and silver (Ag). Specific examples of the alloy include an AlNi alloy and an AlCu alloy. The anode electrode 121 may be configured by a stacked film of metal layers.

### (First cathode electrode, second cathode electrode)

The first cathode electrode 123 is electrically separated for each of the sub-pixels 100R, 100G, and 100B. The first cathode electrode 123 has a facing surface 123S facing the second cathode electrode 124. The first cathode electrode 123 is a transparent electrode having transparency to the light generated in the organic layer 122. Here, the transparent electrode also includes a semi-transmissive reflecting film.

The second cathode electrode 124 is provided as an electrode common to all the sub-pixels 100R, 100G, and 100B in the display region 110A. The second cathode electrode 124 is connected to the first cathode electrode 123 separated for each sub-pixel 100. Specifically, the second cathode electrode 124 includes a plurality of contact portions 124A, and each of the plurality of contact portions 124A is connected to the first cathode electrode 123 separated for each sub-pixel 100. The contact portion 124A has a connecting portion 124B connected to the first cathode electrode 123 at the tip. The number of the connecting portions 124B is, for example, one for one sub-pixel 100. One contact portion 124A is connected to, for example, one sub-pixel 100.

The connecting portion 124B is connected to a part of the facing surface 123S of the first cathode electrode 123. The connecting portion 124B is preferably provided outside the light emitting region 101 of the sub-pixel 110. Since the connecting portion 124B is provided at such a position, it is possible to suppress a decrease in the area of the light emitting region 101. Thus, a decrease in luminance of display device 10 can be suppressed. Furthermore, damage to the organic layer 122 at the time of forming the contact portion 124A can be suppressed.

Fig. 4 is a cross-sectional view taken along line IV-IV of Fig. 3A. However, in Fig. 3A, illustration of some components (the protective layer 14, the protective layer 15, and the like) illustrated in Fig. 4 is omitted. The sub-pixel 100 includes a protruding portion 102 protruding with respect to a part of the peripheral edge of the light emitting region 101. The protruding direction of the protruding portion 102 is an in-plane direction of the display device 10. The protruding portion 102 is configured by the second cathode electrode 124 protruding with respect to the peripheral edge of the light emitting region 101. The organic layer 122 may protrude with respect to the peripheral edge of the light emitting region 101 together with the second cathode electrode 124. The contact portion 124A of the second cathode electrode 124 is connected to the first cathode electrode 123 at the protruding portion 102. The protruding portion 102 may be arranged in a staggered manner in the row direction (see Figs. 3A and 3B), or may be arranged on a straight line extending in the row direction (see Figs. 3C and 3D).

As illustrated in Fig. 3A, in a case where the protruding portion 102 has a substantially elliptical shape, the protruding portion 102 may be provided at one end of the minor axis of the sub-pixel 100 having a substantially elliptical shape. As illustrated in Fig. 3B, in a case where the protruding portion 102 has a substantially hexagonal shape, the protruding portion 102 may be provided at one corner portion of the sub-pixel 100 having a substantially hexagonal shape. As illustrated in Fig. 3C, in a case where the protruding portion 102 has a substantially square shape, the protruding portion 102 may be provided near one corner of the sub-pixel 100 having a substantially square shape. As illustrated in Fig. 3D, in a case where the protruding portion 102 has a substantially rectangular shape, the protruding portion 102 may be provided on one short side of the sub-pixel 100 having a substantially rectangular shape. Fig. 3D illustrates an example in which the entire short side protrudes, but a part of the short side may protrude.

As illustrated in Figs. 3A to 3D, the connecting portion 124B of the contact portion 124A may have a dot shape. When the connecting portion 124B is viewed in a plan view from a direction perpendicular to the display surface of the display device 10, the dotted connecting portion 124B may have a substantially quadrangular shape such as a substantially square shape or a substantially rectangular shape. The number of the connecting portions 124B is preferably one for one sub-pixel 100. In this case, by providing the connecting portion 124B, it is possible to suppress a decrease in the area of the light emitting region 101. Thus, a decrease in luminance of display device 10 can be suppressed.

The first cathode electrode 123 and the second cathode electrode 124 each independently include, for example, a transparent metal oxide, metal, or alloy. The transparent metal oxide contains, for example, at least one selected from the group consisting of indium-zinc oxide (IZO), indium-tin oxide (ITO), zinc oxide (ZnO), tin oxide (SnO), aluminum-zinc oxide (AZO), and gallium-zinc oxide (GZO). The metal contains, for example, at least one selected from the group consisting of aluminum (Al), silver (Ag), magnesium (Mg), calcium (Ca), sodium (Na), and strontium (Sr). The alloy includes, for example, at least one selected from the group consisting of an alloy of an alkali metal or an alkaline earth metal and silver (Ag), an alloy of magnesium (Mg) and silver (Ag), an alloy of magnesium (Mg) and calcium (Ca), and an alloy of aluminum (Al) and lithium (Li).

The first cathode electrode 123 includes a transparent metal oxide (for example, a transparent conductive material such as IZO), and the second cathode electrode 124 may include a metal or an alloy (for example, a high reflectance material such as MgAg). In a case where the first cathode electrode 123 and the second cathode electrode 124 have such a configuration, a resonator structure may be configured by the anode electrode 121 and the second cathode electrode 124 in each of the sub-pixels 100R, 100G, and 100B.

The first cathode electrode 123 includes a metal or an alloy (for example, a high reflectance material such as MgAg), and the second cathode electrode 124 may include a transparent metal oxide (for example, a transparent conductive material such as IZO). In a case where the first cathode electrode 123 and the second cathode electrode 124 have such a configuration, a resonator structure may be configured by the anode electrode 121 and the first cathode electrode 123 in each of the sub-pixels 100R, 100G, and 100B. Note that details of the resonator structure will be described in Modification 2 to be described later.

### (Insulating layer)

The insulating layer 13 electrically separates the anode electrode 121 from each of the sub-pixels 100R, 100G, and 100B. The insulating layer 13 is provided between the anode electrodes 121 and covers the peripheral edge portion of the anode electrode 121. More specifically, the insulating layer 13 has an opening in a portion corresponding to each anode electrode 121, and covers from a peripheral edge portion of an upper surface (a surface facing the first cathode electrode 123) of the anode electrode 121 to a side surface (end surface) of the anode electrode 121.

The insulating layer 13 includes, for example, an organic material or an inorganic material. The organic material includes, for example, at least one of a polyimide resin and an acrylic resin. The inorganic material includes, for example, at least one selected from the group consisting of silicon oxide, silicon nitride, silicon oxynitride, and aluminum oxide.

### (Organic layer)

The organic layers 122R, 122G, and 122B are electrically separated for each of the sub-pixels 100R, 100G, and 100B. The organic layers 122R, 122G, and 122B generate red light, green light, and blue light, respectively. Since the organic layers 122R, 122G, and 122B have the same layer configuration, the layer configuration of the organic layer 122R will be described below.

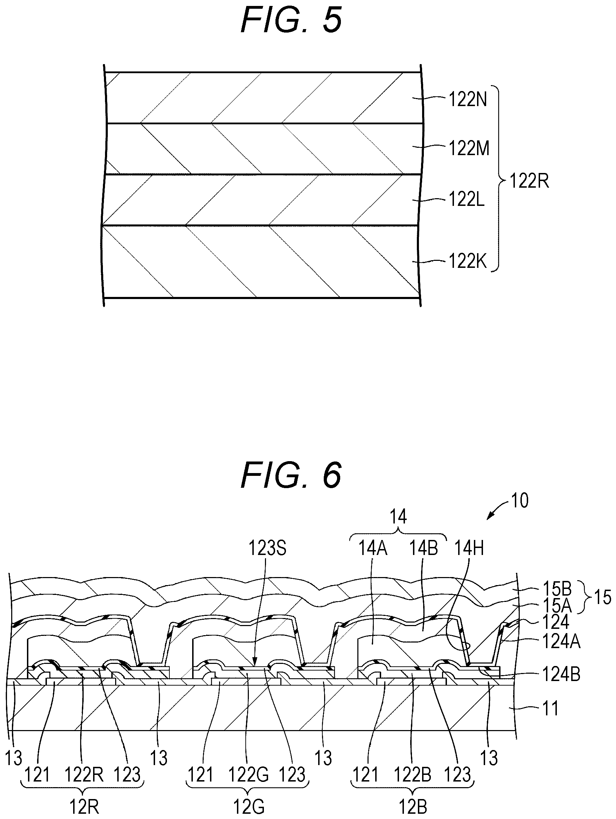

Fig. 5 is an enlarged cross-sectional view illustrating the organic layer 122R illustrated in Fig. 2. The organic layer 122 has a configuration in which a hole injection layer 122K, a hole transport layer 122L, an organic light emitting layer 122M, and an electron transport layer 122N are stacked in this order from the anode electrode 121 side. Note that the configuration of the organic layer 122 is not limited thereto, and layers other than the organic light emitting layer 122M are provided as necessary.

The hole injection layer 122K is a buffer layer for enhancing hole injection efficiency into the organic light emitting layer 122M and suppressing leakage. The hole transport layer 122L is for enhancing hole transport efficiency to the organic light emitting layer 122M. The organic light emitting layer 122M generates light by recombination of electrons and holes by applying an electric field. The electron transport layer 122N is for enhancing electron transport efficiency to the organic light emitting layer 122M. An electron injection layer (not illustrated) may be provided between the electron transport layer 122N and the first cathode electrode 123. The electron injection layer is for enhancing electron injection efficiency.

### (Protective layer)

The protective layer 14 covers and protects the plurality of light emitting elements 12. Specifically, the protective layer 14 prevents the organic layer 122 from being damaged by being exposed to a process gas, a chemical liquid, and the like in a manufacturing process. Furthermore, the protective layer 14 suppresses moisture infiltration into the light emitting element 12 from an external environment. In a case where the first cathode electrode 123 is configured by a metal layer, the protective layer 14 may have a function of suppressing oxidation of the metal layer.

The protective layer 15 covers and protects the second cathode electrode 124. Specifically, the protective layer 15 prevents moisture from reaching the second cathode electrode 124 from the external environment and moisture from entering the light emitting element 12 from the external environment. In a case where the second cathode electrode 124 is configured by a metal layer, the protective layer 15 may have a function of suppressing oxidation of the metal layer.

The protective layer 14 is provided between the first cathode electrode 123 and the second cathode electrode 124 and between the adjacent sub-pixels 100. The protective layer 14 has a plurality of contact holes 14H penetrating in the thickness direction of the protective layer 14. The contact hole 14H is for connecting the first cathode electrode 123 and the second cathode electrode 124, and the contact portion 124A of the second cathode electrode 124 is arranged in the contact hole 14H. The contact hole 14H is preferably provided outside the light emitting region 101. Since the contact hole 14H is provided at such a position, it is possible to suppress a decrease in the area of the light emitting region 101. Thus, a decrease in luminance of display device 10 can be suppressed. Furthermore, damage to the organic layer 122 at the time of forming the contact hole 14H can be suppressed.

The thickness of the protective layer 14 on the separated first cathode electrode 123 is substantially the same in the red, green, and blue sub-pixels 100R, 100G, and 100B.

The protective layer 14 contains, for example, at least one of an inorganic oxide and an organic insulating material. The inorganic oxide contains, for example, at least one selected from the group consisting of silicon nitride (SiN), silicon oxide (SiO), silicon oxynitride (SiON), aluminum oxide (AlO), and titanium oxide (TiO). The organic insulating material contains, for example, at least one of a thermosetting resin and an ultraviolet curable resin.

Although Fig. 2 illustrates an example in which the protective layers 14 and 15 are single layer films, the protective layer 14 may be a multilayer film or a multilayer film as illustrated in Fig. 6. It is preferable that the layers constituting the multilayer film contain materials different from each other. This is because the formation of the pinholes connected between the layers can be suppressed.

The protective layer 14 as a multilayer film includes, for example, a first protective layer 14A and a second protective layer 14B. The first protective layer 14A and the second protective layer 14B preferably contain materials different from each other. This is because it is possible to prevent the pinhole generated in the first protective layer 14A from being also connected to the second protective layer 14B. The protective layer 15 having a multilayer structure includes, for example, a first protective layer 15A and a second protective layer 15B. The first protective layer 15A and the second protective layer 15B preferably contain materials different from each other. This is because it is possible to prevent the pinhole generated in the first protective layer 15A from being also connected to the second protective layer 15B.

The first protective layer 14A and the first protective layer 15A include, for example, silicon nitride (SiN). The second protective layer 14B and the second protective layer 15B include, for example, aluminum oxide (A10). The second protective layer 14B and the second protective layer 15B are preferably formed by atomic layer deposition (ALD).

In the above description, an example in which the protective layer 14 and the protective layer 15 having a multilayer structure include two protective layers has been described, but two or more protective layers may be provided.

### [1.2 Method of manufacturing display device]

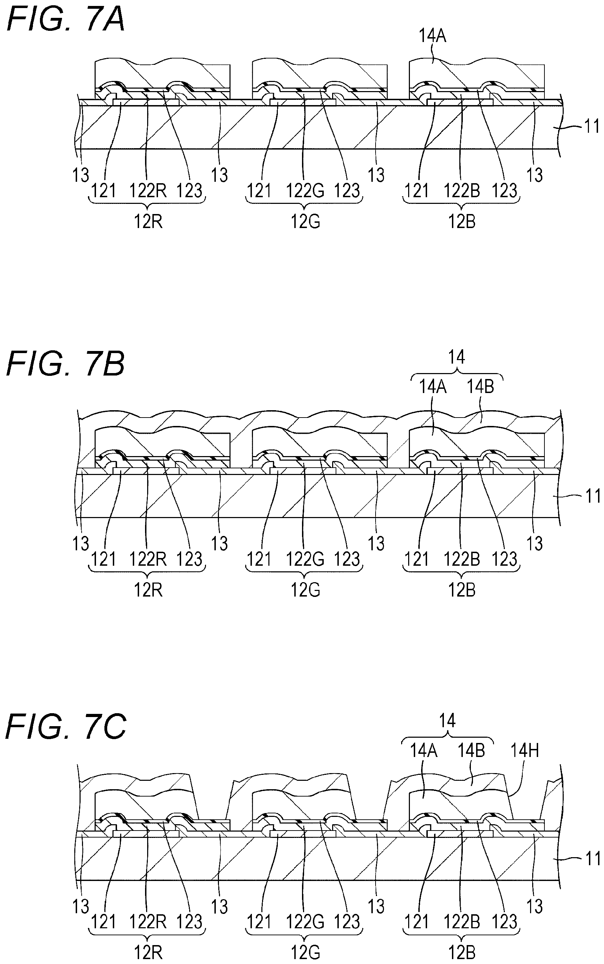

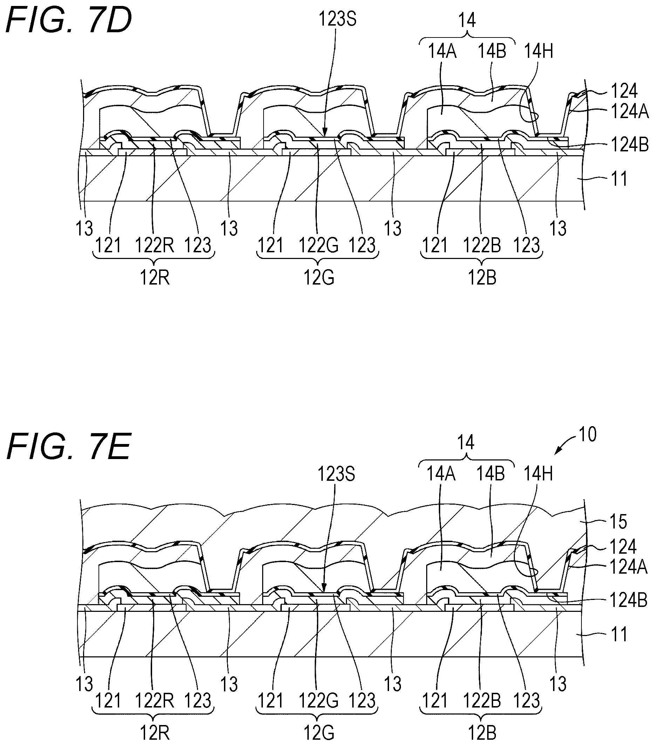

Hereinafter, a method of manufacturing the display device 10 having the above-described configuration will be described with reference to Figs. 7A, 7B, 7C, 7D, and 7E.

First, a drive circuit and the like are formed on one main surface of the substrate 11 by using, for example, a thin film forming technique, a photolithography technique, and an etching technique. Next, a metal layer is formed on the drive circuit and the like by, for example, a sputtering method, and then the metal layer is patterned by, for example, a photolithography technique and an etching technique, thereby forming the separated anode electrode 121 for each light emitting element 12 (that is, for each sub-pixel 100).

Next, the insulating layer 13 is formed by, for example, a CVD method. Next, the insulating layer 13 is patterned using a photolithography technique and an etching technique.

Next, the hole injection layer 122K, the hole transport layer 122L, the organic light emitting layer 122M, and the electron transport layer 122N are sequentially stacked on the anode electrode 121 by, for example, a vapor deposition method to form the organic layer 122R. Next, the first cathode electrode 123 is formed on the organic layer 122R by, for example, a sputtering method.

Next, the first protective layer 14A as a hard mask is formed on the first cathode electrode 123 by, for example, a CVD method. Next, a resist is applied onto the first protective layer 14A to form a resist layer. Next, the resist layer is processed by photolithography to form a resist pattern, and then the first protective layer 14A as a hard mask is etched through the resist pattern. Thereafter, the resist pattern is removed.

Next, the organic layer 122R and the first cathode electrode 123 are etched using the first protective layer 14A as a hard mask. Therefore, as illustrated in Fig. 7A, the organic layer 122R and the first cathode electrode 123 separated for each sub-pixel 100 are formed on the anode electrode 121, and a plurality of light emitting elements 12R is obtained.

Next, as illustrated in Fig. 7A, the plurality of light emitting elements 12G and the plurality of light emitting elements 12B are formed on one main surface of the substrate 11 in the procedure similar to the forming of the light emitting element 12R described above. Next, as illustrated in Fig. 7B, the second protective layer 14B is formed so as to cover the plurality of light emitting elements 12 by, for example, a CVD method. Therefore, the protective layer 14 which is a stacked film of the first protective layer 14A and the second protective layer 14B is formed. Next, a resist is applied onto the second protective layer 14B to form a resist layer. Next, a resist layer is processed by photolithography to form a resist pattern, and then the protective layer 14 is etched through the resist pattern. Therefore, as illustrated in Fig. 7C, the contact hole 14H for connecting the first cathode electrode 123 and the second cathode electrode 124 is formed in the protective layer 14. Next, the resist pattern is removed.

Next, as illustrated in Fig. 7D, the second cathode electrode 124 is formed on the protective layer 14 so as to follow the contact hole 14H by, for example, a sputtering method. Next, as illustrated in Fig. 7E, the protective layer 15 is formed on the second cathode electrode 124 by, for example, a CVD method so as to fill the contact hole 14H. As described above, the display device 10 illustrated in Fig. 2 is obtained.

### [1.3 Operational effect]

In the display device 10 according to the first embodiment described above, the protective layer 14 is provided between the first cathode electrode 123 and the second cathode electrode 124. Therefore, in the step of etching the organic layer 122 and the first cathode electrode 123 and the like, the exposure of the organic layer 122 to a process gas, a chemical liquid, and the like can be suppressed by the protective layer 14. That is, the organic layer 122 can be prevented from being damaged. Thus, it is possible to suppress a decrease in reliability of the display device 10.

Furthermore, the anode electrode 121, the organic light emitting layer 122M, and the first cathode electrode 123 are separated for each sub-pixel 100, and the insulating protective layer 14 is provided between the sub-pixels 100. Therefore, a leakage current between the adjacent sub-pixels 100 can be suppressed. Thus, color mixing can be suppressed, and color reproducibility can be improved. Furthermore, luminous efficiency can also be improved. Accordingly, the characteristics of the display device 10 can be improved.

Furthermore, since the second cathode electrode 124 is connected to the protruding portion 102 of the first cathode electrode 123 via the contact portion 124A, the contact resistance between the first cathode electrode 123 and the second cathode electrode 124 can be reduced.

### [1.4 Modifications]

### (Modification 1)

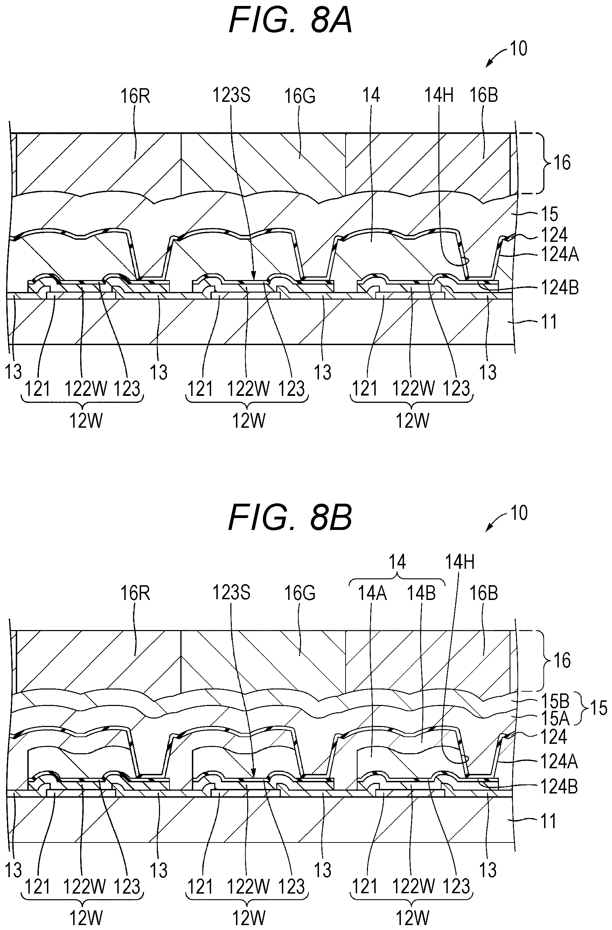

In the first embodiment described above, an example has been described in which the display device 10 includes the plurality of light emitting elements 12R, 12G, and 12B configured to be capable of emitting red light, green light, and blue light, respectively, but the coloring method is not limited thereto. For example, as illustrated in Fig. 8A, the display device 10 may include a plurality of light emitting elements 12W configured to emit white light and a color filter 16 instead of the plurality of light emitting elements 12R, 12G, and 12B. The light emitting element 12W is, for example, a white OLED, a MOLED (Micro-white OLED), or a Micro-white LED.

The color filter 16 is, for example, an OCCF (on-chip color filter), and is provided on the protective layer 15. The color filter 16 includes, for example, a red filter 16R, a green filter 16G, and a blue filter 16B. The red filter 16R, the green filter 16G, and the blue filter 16B are provided to face the light emitting element 12W of the sub-pixel 100R, the light emitting element 12W of the sub-pixel 100G, and the light emitting element 12W of the sub-pixel 100B, respectively. Therefore, the white light emitted from each light emitting element 12W in the sub-pixel 100R, the sub-pixel 100G, and the sub-pixel 100B passes through the red filter 16R, the green filter 16G, and the blue filter 16B described above, respectively, whereby the red light, the green light, and the blue light are emitted from the display surface, respectively. Furthermore, a light shielding layer (not illustrated) may be provided between the color filters 16R, 16G, and 16B of the respective colors, that is, in a region between the sub-pixels 100R, 100G, and 100B of the respective colors.

In Modification 1 described above, an example in which the protective layers 14 and 15 have a single layer structure has been described. However, as illustrated in Fig. 8B, the protective layer 14 may have a multilayer structure, or the protective layer 15 may have a multilayer structure.

In Modification 1 described above, an example in which the color filter 16 is an on-chip color filter has been described, but a counter color filter provided on one main surface of a counter substrate may be used.

### (Modification 2)

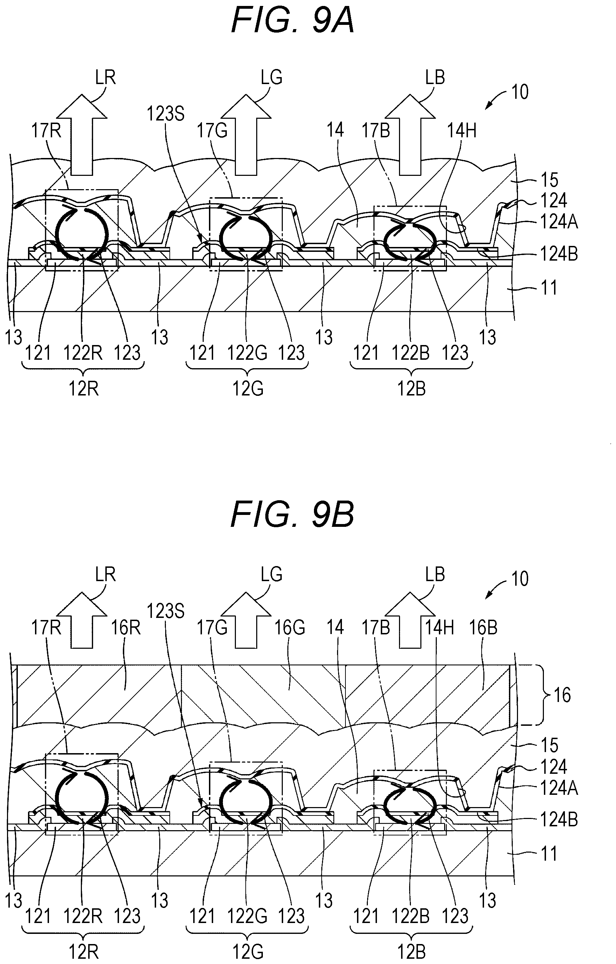

As illustrated in Fig. 9A, the sub-pixels 100R, 100G, and 100B may be provided with resonator structures 17R, 17R, and 17B, respectively. The resonator structures 17R, 17R, and 17B resonate, emphasize, and emit light of a prescribed wavelength. Specifically, the resonator structures 17R, 17R, and 17B respectively resonate a red light LR, a green light LG, and a blue light LB generated in the light emitting elements 12R, 12G, and 12B, specifically, the organic layers 122R, 122G, and 122B, and emphasize and emit the red light LR, the green light LG, and the blue light LB. As described above, the sub-pixels 100R, 100G, and 100B further include the resonator structures 17R, 17R, and 17B, respectively, so that color purity can be improved and high luminance can be realized.

The resonator structures 17R, 17R, and 17B are configured by an anode electrode 121 and a second cathode electrode 124. The thickness of the protective layer 14 on the separated first cathode electrode 123 is different for each of the red, green, and blue sub-pixels 100R, 100G, and 100B. Specifically, the thickness of the protective layer 14 of each of the sub-pixels 100R, 100G, and 100B is different according to the color to be displayed by each of the sub-pixels 100R, 100G, and 100B. Since the protective layers 14 have such different thicknesses, the optical distance between the anode electrode 121 and the second cathode electrode 124 can be set so as to generate optimum resonance for the wavelength of light corresponding to the color to be displayed.

The second cathode electrode 124 preferably functions as a semi-transmission reflection film. The second cathode electrode 124 preferably contains magnesium (Mg), silver (Ag), a magnesium-silver alloy (MgAg) containing these as main components, an alloy containing an alkali metal or an alkaline earth metal, or the like. The first cathode electrode 123 preferably contains a transparent metal oxide.

As illustrated in Fig. 9B, the display device 10 may include the resonator structures 17R, 17G, and 17B described above for the respective sub-pixels 100R, 100G, and 100B, and may further include the color filter 16 described in Modification 1. In this case, color reproducibility can be further improved.

In Modification 2 described above, the example in which the resonator structures 17R, 17R, and 17B are configured by the anode electrode 121 and the second cathode electrode 124 has been described, but the resonator structures 17R, 17R, and 17B may be configured by the anode electrode 121 and the first cathode electrode 123. In this case, the thicknesses of the organic layers 122R, 122G, and 122B of the sub-pixels 100R, 100G, and 100B are different according to the colors to be displayed by the sub-pixels 100R, 100G, and 100B, respectively. Since the protective layer 14 has such different thicknesses, the optical distance between the anode electrode 121 and the first cathode electrode 123 can be set so as to generate optimum resonance for the wavelength of light corresponding to the color to be displayed.

As described above, in a case where the resonator structures 17R, 17R, and 17B are configured by the anode electrode 121 and the first cathode electrode 123, the first cathode electrode 123 preferably functions as a semi-transmission reflection film. The second cathode electrode 124 preferably contains magnesium (Mg), silver (Ag), a magnesium-silver alloy (MgAg) containing these as main components, an alloy containing an alkali metal or an alkaline earth metal, or the like. The second cathode electrode 124 preferably contains a transparent metal oxide.

### (Modification 3)

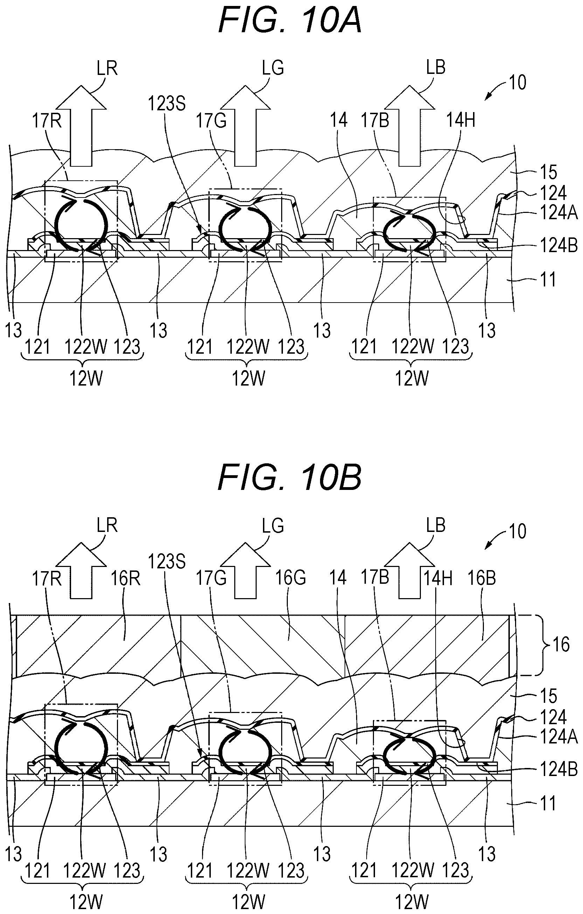

In Modification 2 described above, an example has been described in which the display device 10 includes the red, green, and blue light emitting elements 12R, 12G, and 12B and the resonator structures 17R, 17R, and 17B that resonate light of a prescribed wavelength generated by these light emitting elements 12R, 12G, and 12B. However, as illustrated in Fig. 10A, the light emitting element 12W may be provided instead of the light emitting elements 12R, 12G, and 12B. In this case, the resonator structures 17R, 17R, and 17B resonate the red light LR, the green light LG, and the blue light LB contained in the white light generated by the light emitting element 12W, specifically, the organic layer 122W, and emit the red light LR, the green light LG, and the blue light LB to the outside, respectively.

By using the configuration of Modification 3 described above, full color display or the like can be performed even if the display device 10 does not include the red, green, and blue light emitting elements 12R, 12G, and 12B or the color filter 16.

As illustrated in Fig. 10B, the display device 10 may include the resonator structures 17R, 17G, and 17B described above for the respective sub-pixels 100R, 100G, and 100B, and may further include the color filter 16 described in Modification 1. In this case, color reproducibility can be further improved.

### (Modification 4)

In the first embodiment described above, an example in which the sub-pixel 100 has the protruding portion 102 protruding with respect to the peripheral edge of the light emitting region 101 has been described. However, as illustrated in Figs. 11A, 11B, and 11C, a cutout portion (concave portion) 103 may be provided in which a part of the peripheral edge of the light emitting region 101 is cut out.

Fig. 11A is a plan view illustrating an example of a substantially elliptical sub-pixel 100 having a cutout portion 103. The cutout portion 103 is provided, for example, at one end of the short axis of the substantially elliptical shape.

Fig. 11B is a plan view illustrating an example of a substantially hexagonal sub-pixel 100 having the cutout portion 103. The cutout portion 103 is provided, for example, at one corner portion of a substantially hexagonal shape.

Fig. 11C is a plan view illustrating an example of the sub-pixel 100 having a substantially square shape and having the cutout portion 103. The cutout portion 103 is provided, for example, in the vicinity of one corner portion of a substantially square shape.

The cutout portions 103 of the respective sub-pixels 100 may be arranged in a staggered manner in the row direction (see Figs. 11A and 11B), or may be arranged on a straight line extending in the row direction (see Fig. 11C).

Fig. 12 is a cross-sectional view taken along line XII-XII of Fig. 11A. However, in Fig. 11A, illustration of some components (the protective layer 14, the protective layer 15, and the like) illustrated in Fig. 12 is omitted. The cutout portion 103 is configured by recessing a part of the peripheral edge of the anode electrode 121 inside the peripheral edge of the first cathode electrode 123. The organic layer 122 may or may not be provided under the first cathode electrode 123 of the cutout portion 103. Fig. 12 illustrates an example of the former. The contact portion 124A of the second cathode electrode 124 is connected to the first cathode electrode 123 in the cutout portion 103.

### (Modification 5)

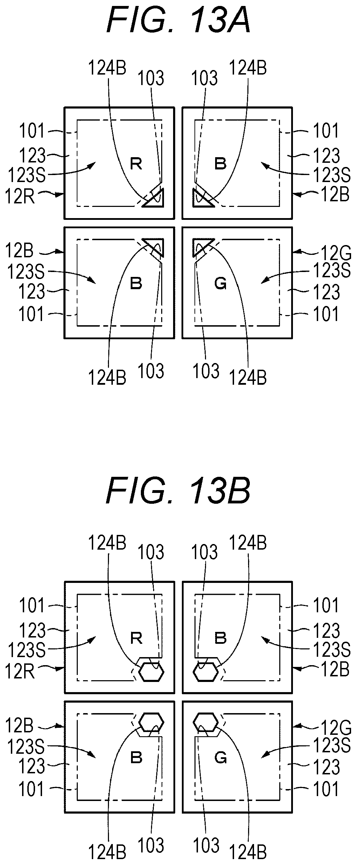

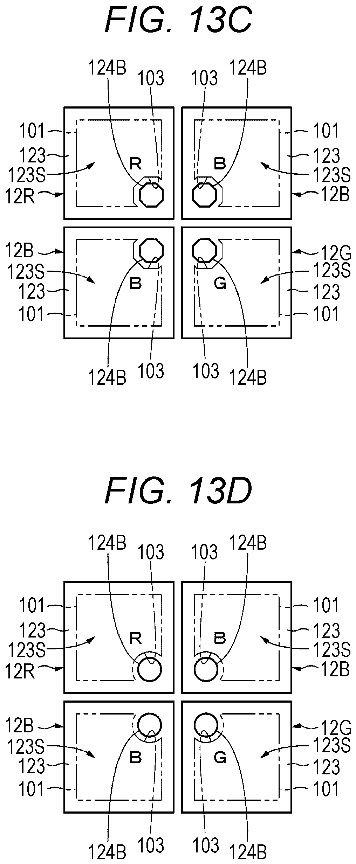

In the first embodiment described above, an example in which the connecting portion 124B of the contact portion 124A has a substantially square shape has been described, but the shape of the connecting portion 124B is not limited to a substantially square shape. For example, the connecting portion 124B may have a substantially polygonal shape such as a substantially triangular shape (see Fig. 13A), a substantially hexagonal shape (see Fig. 13B), or a substantially octagonal shape (see Fig. 13C), or may have a substantially circular shape (see Fig. 13D).

### (Modification 6)

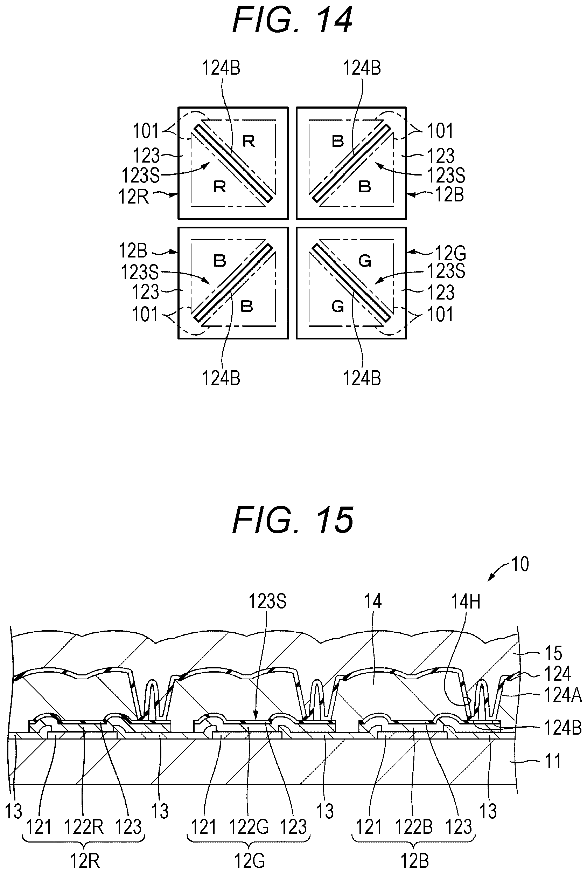

In the first embodiment described above, an example in which the connecting portion 124B of the second cathode electrode 124 has a dot shape has been described. However, as illustrated in Fig. 14, the connecting portion 124B may have a linear shape. For example, in a case where the sub-pixel 100 has a substantially quadrangular shape such as a substantially square shape, the linear connecting portion 124B may be provided on a diagonal line of the substantially quadrangular sub-pixel 100.

### (Modification 7)

In the first embodiment described above, an example in which the number of the connecting portions 124B is one for one sub-pixel 100 has been described, but as illustrated in Fig. 15, the number may be two or more for one sub-pixel 100. In this case, the contact resistance between the first cathode electrode 123 and the second cathode electrode 124 can be further reduced.

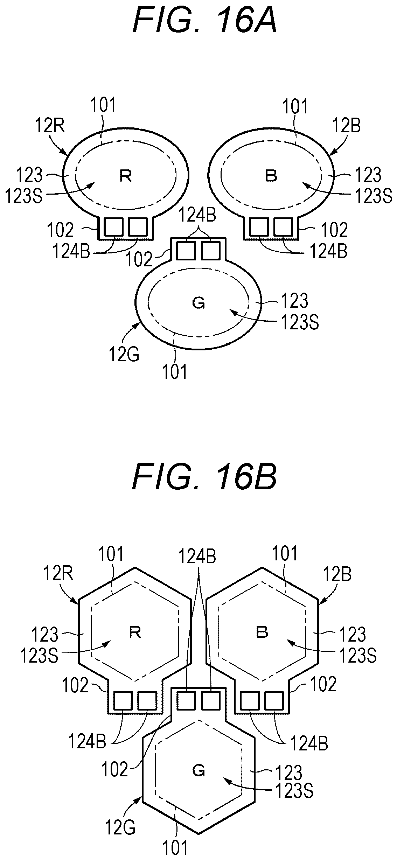

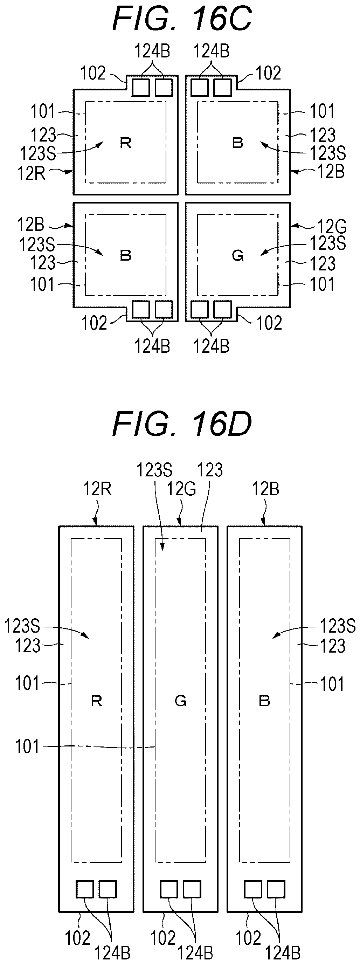

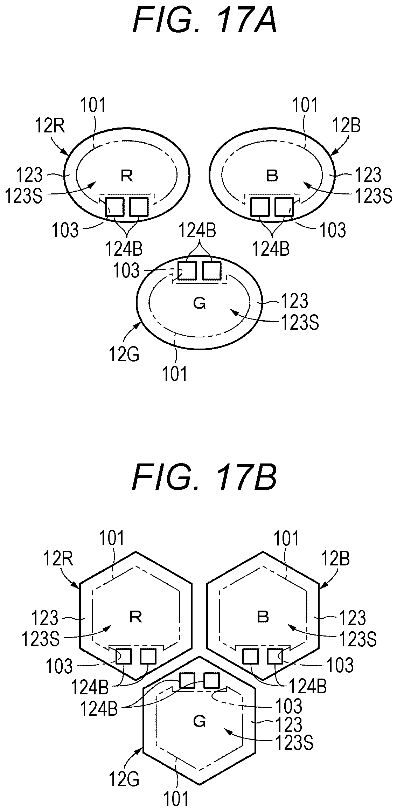

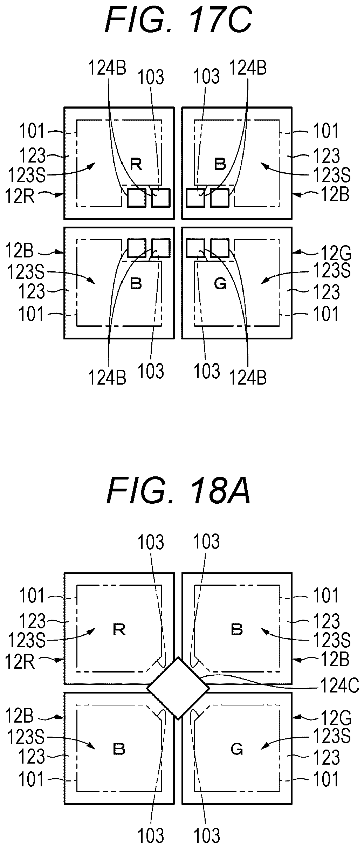

For example, as illustrated in Figs. 16A, 16B, 16C, and 16D, two or more connecting portions 124B may be connected to one protruding portion 102 of the sub-pixel 100 having a substantially elliptical shape, a substantially hexagonal shape, a substantially square shape, or a substantially rectangular shape. Alternatively, as illustrated in Figs. 17A, 17B, and 17C, two or more connecting portions 124B may be connected to one cutout portion 103 of the sub-pixel 100 having a substantially elliptical shape, a substantially hexagonal shape, or a substantially square shape.

In the example described above, an example in which the sub-pixel 100 has one protruding portion 102 and two or more connecting portions 124B are connected to one protruding portion 102 has been described. However, the sub-pixel 100 may have two or more protruding portions 102 and one or two or more connecting portions 124B may be connected to each protruding portion 102.

### (Modification 8)

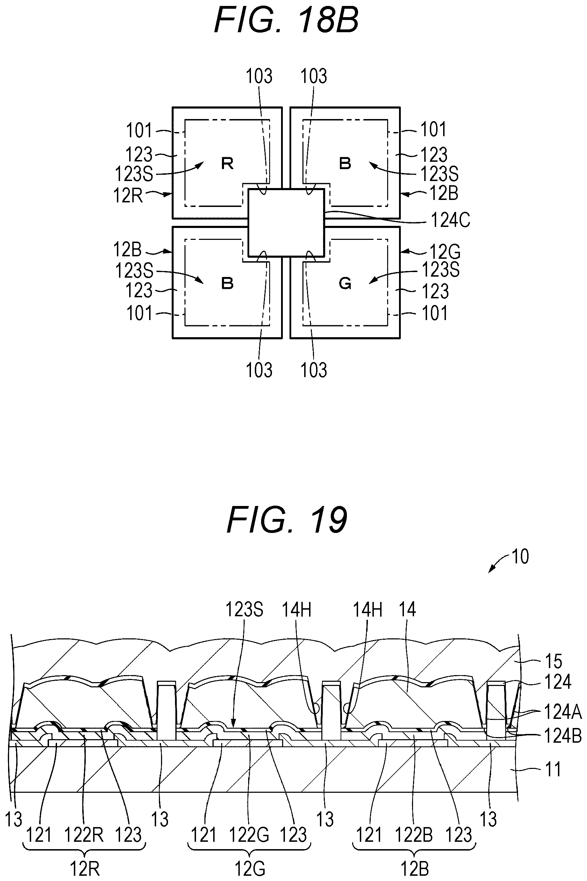

In the first embodiment described above, an example in which one contact portion 124A is connected to one sub-pixel 100 has been described. However, as illustrated in Figs. 18A and 18B, one contact portion 124A may be connected to two or more adjacent sub-pixels 100, specifically, for example, two, three, or four adjacent sub-pixels 100, and may be shared by two or more sub-pixels 100. Since one contact portion 124A is connected to two or more sub-pixels 100, it is possible to suppress a decrease in the area of the light emitting region 101. Thus, a decrease in luminance of display device 10 can be suppressed. Furthermore, since the number of contact portions 124A can be reduced, damage to the organic layer 122 at the time of forming the contact portion 124A can be suppressed. The contact portion 124A is connected to two or more adjacent sub-pixels 100 and includes one shared connecting portion 124C that is shared. In the protective layer 14, one contact hole 14H may be provided for two or more sub-pixels 100.

Fig. 18A illustrates an example in which the shared connecting portion 124C of one contact portion 124A is connected to four adjacent sub-pixels 100 and is shared by the four sub-pixels 100. Although Fig. 18A illustrates an example in which the cutout portion 103 has a substantially triangular shape, the cutout portion 103 may have a substantially rectangular shape as illustrated in Fig. 18B.

Although Figs. 18A and 18B illustrate an example in which the shared connecting portion 124C is connected to the cutout portion 103, the shared connecting portion 124C may be connected to the protruding portion 102. Although Figs. 18A and 18B illustrate an example in which the connecting portion 124B is substantially square, the connecting portion may be substantially polygonal, substantially circular, linear, or the like other than substantially square.

### (Modification 9)

In the first embodiment described above, an example has been described in which the contact portion 124A has the dotted connecting portion 124B, and the dotted connecting portion 124B is connected to the protruding portion 102 of the sub-pixel 100, but the shape and connection form of the connecting portion 124B are not limited thereto.

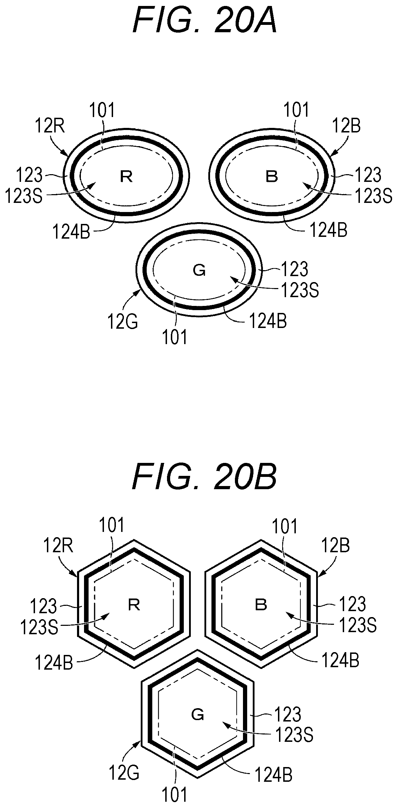

Fig. 19 is a cross-sectional view illustrating a modification of the shape and the connection form of the connecting portion 124B. Fig. 20A is a plan view illustrating a modification of the shape and the connection form of the connecting portion 124B. As illustrated in Figs. 19 and 20A, the contact portion 124A may have a linear connecting portion 124B. The linear connecting portion 124B may be provided along the peripheral edge of the facing surface 123S of the first cathode electrode 123.

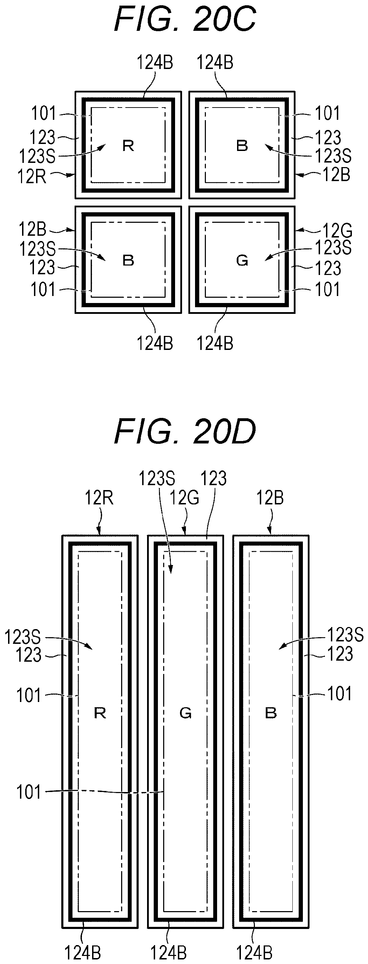

Fig. 20A illustrates an example in which the substantially elliptical connecting portion 124B is provided in the substantially elliptical sub-pixel 100. However, as illustrated in Figs. 20B, 20C, and 20D, the substantially polygonal connecting portion 124B such as a substantially hexagonal shape, a substantially square shape, and a substantially rectangular shape may be provided in the substantially polygonal sub-pixel 100 such as a substantially hexagonal shape, a substantially square shape, and a substantially rectangular shape. Figs. 20A, 20B, 20C, and 20D illustrate examples in which the linear connecting portion 124B is continuously provided along the peripheral edge of the facing surface 123S of the first cathode electrode 123, but may be discontinuously provided.

### (Modification 10)

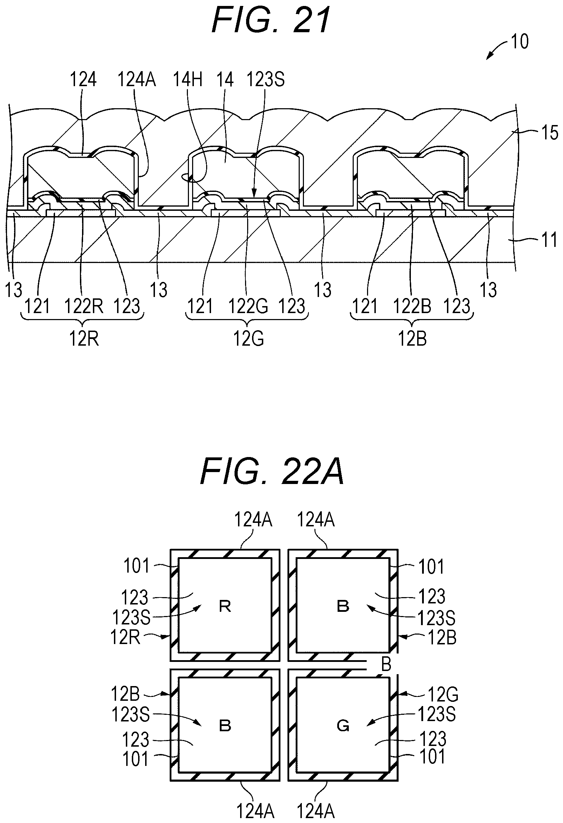

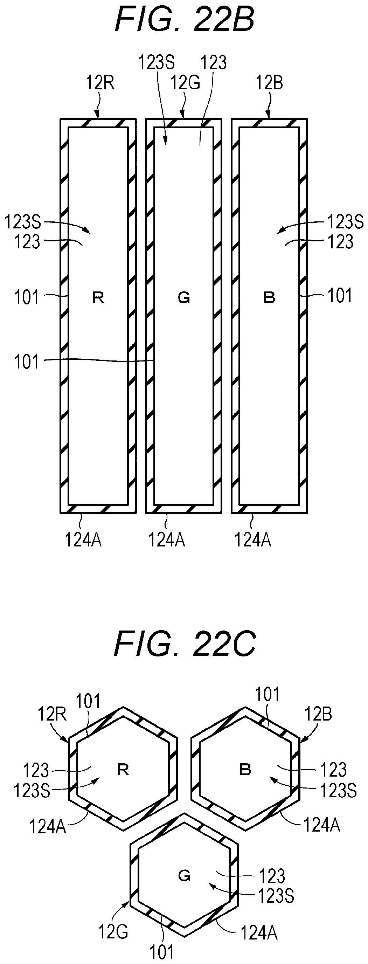

In Modification 9 described above, an example in which the contact portion 124A is connected to the facing surface 123S of the first cathode electrode 123 has been described, but as illustrated in Fig. 21, the contact portion may be connected to an end portion (side surface) of the first cathode electrode 123. As illustrated in Figs. 22A, 22B, and 22C, the contact portion 124A may be connected to the first cathode electrode 123 in the entire periphery of the end portion (side surface) of the first cathode electrode 123 of the sub-pixel 100 having a substantially square shape, a substantially rectangular shape, a substantially hexagonal shape, or the like, or may be connected to the first cathode electrode 123 in a part of the entire periphery of the end portion (side surface) of the first cathode electrode 123. The tip of the contact portion 124A may be arranged between the adjacent sub-pixels 100.

Since the display device 10 has the configuration of Modification 10, it is not necessary to separately provide the connecting portions (for example, the protruding portion 102 (see Figs. 3A, 3B, 3C and 3D) and the cutout portion 103 (see Figs. 11A, 11B, and 11C)) for connecting the second cathode electrode 124 to the first cathode electrode 123 for each sub-pixel 100. Thus, in the display device 10 having the configuration of Modification 10, the sub-pixel 100 can be miniaturized as compared with the display device 10 in which a connecting portion is separately provided for each sub-pixel 100.

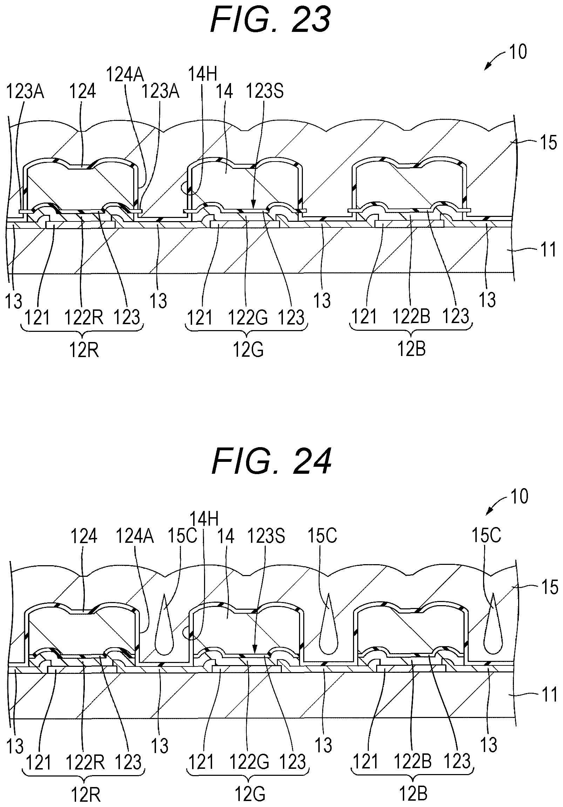

As illustrated in Fig. 23, the first cathode electrode 123 may have a protruding portion 123A that intersects with the contact portion 124A. The protruding portion 123A may have a configuration protruding with respect to the peripheral edge of the organic layer 122. Since the first cathode electrode 123 has the protruding portion 123A, the contact portion 124A is easily connected to the first cathode electrode 123 at the end portion (side surface) of the sub-pixel 100. Thus, a connection failure between the contact portion 124A and the first cathode electrode 123 can be suppressed.

### (Modification 11)

As illustrated in Fig. 24, the protective layer 15 may have a plurality of air gaps 15C. The air gap 15C is provided between the adjacent sub-pixels 100. Since the protective layer 15 has the air gap 15C, the light emitted to the side of the light emitting element 12 can be reflected and extracted to the outside. Thus, the luminance of display device 10 can be improved. The air gap 15C is preferably provided so as to surround the light emitting element 12. The air gap 15C may have a wall shape.

### < 2 Second embodiment >

### [2.1 Configuration of display device]

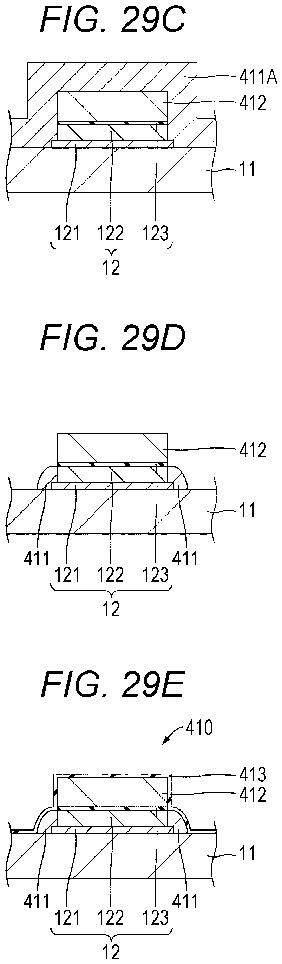

Fig. 29E is a cross-sectional view illustrating an example of a configuration of a display device 410 according to a second embodiment of the present disclosure. The display device 410 includes a sidewall 411, a protective layer 412, and a second cathode electrode 413. Note that, in the second embodiment, the same reference numerals are given to the parts similar to those of the first embodiment, and the description thereof will be omitted.

### (Sidewall)

The sidewall 411 covers the side surface of the anode electrode 121 and the side surface of the organic layer 122. The sidewall 411 is configured by an insulating material. As the insulating material, a material similar to the insulating layer 13 in the first embodiment can be exemplified.

### (Protective layer)

The protective layer 412 is for protecting the light emitting element 12. The protective layer 412 is provided on the light emitting element 12. The protective layer 412 is separated for each light emitting element 12. As a material of the protective layer 412, a material similar to that of the protective layer 14 in the first embodiment can be exemplified.

### (Second cathode electrode)

The second cathode electrode 413 covers the light emitting element 12 in which the protective layer 412 and the sidewall 411 are provided. The second cathode electrode 413 covers the side surface of the protective layer 412 and the side surface of 123 of the first cathode. The second cathode electrode 413 is connected to a side surface or a peripheral edge portion of the first cathode electrode 123.

### [2.2 Method of manufacturing display device]

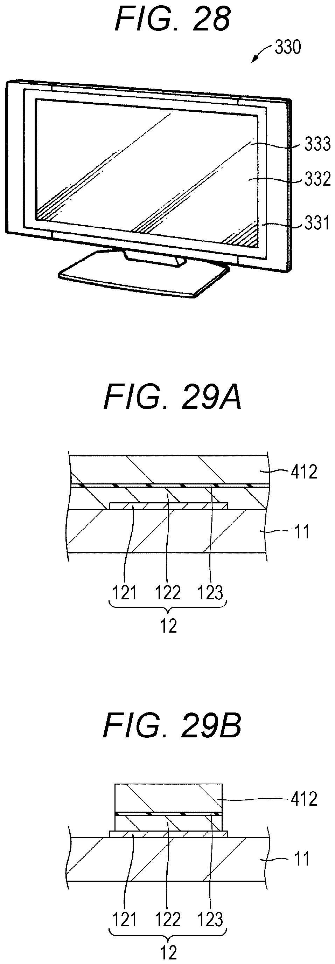

Hereinafter, an example of a method of manufacturing the display device 410 having the above configuration will be described with reference to Figs. 29A to 29E.

First, the anode electrode 121 separated for each light emitting element 12 is formed on one main surface of the substrate 11. Next, as illustrated in Fig. 29A, the organic layer 122, the first cathode electrode 123, and the protective layer 412 are sequentially stacked on one main surface of the substrate 11.

Next, as illustrated in Fig. 29B, the organic layer 122, the first cathode electrode 123, and the protective layer 412 are processed using, for example, a photolithography technique and an etching technique, and are separated for each light emitting element 12. Therefore, a plurality of stacked bodies including the light emitting element 12 and the protective layer 412 is formed on one main surface of the substrate 11. Next, as illustrated in Fig. 29C, an insulating layer 411A is formed on one main surface of the substrate 11, and the plurality of stacked bodies is covered with the insulating layer 411A.

Next, as illustrated in Fig. 29D, the insulating layer 411A is processed by, for example, anisotropic etching to form the sidewall 411. Next, as illustrated in Fig. 29E, the second cathode electrode 413 is formed on one main surface of the substrate 11 to cover the light emitting element 12 provided with the protective layer 412 and the sidewall 411. Therefore, the second cathode electrode 413 is connected to the side surface or the peripheral edge portion of the first cathode electrode 123.

### [2.3 Operational effect]

In the display device 410 according to the second embodiment, since the first cathode electrode 123 and the second cathode electrode 124 are not connected using the contact portion 124A (see Fig. 2), there is no influence of an increase in resistance by the contact portion 124A.

Furthermore, since the display device 410 can be manufactured without using a lithography process using a solution, the yield can be improved as compared with a configuration using the contact portion 124A. Since there is no restriction caused by the lithography process, such as the exposure limit or overlapping of the pattern with the contact portion 124A, the definition of the pixel can be increased.

### [2.4 Modifications]

### (Modification 1)

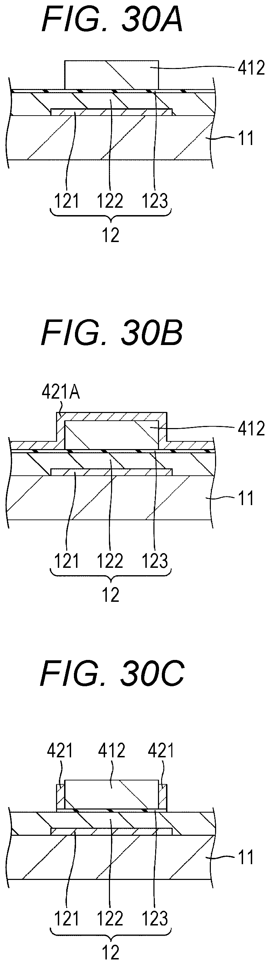

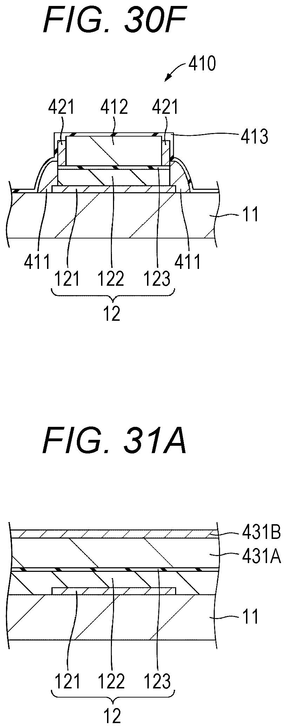

As illustrated in Fig. 30F, a display device 420 may include a sidewall portion 421 that covers a side surface of the protective layer 412. The sidewall portion 421 is an auxiliary electrode and has conductivity. The sidewall portion 421 is provided at a peripheral edge portion of the upper main surface of the first cathode electrode 123. The second cathode electrode 413 covers the sidewall portion 421 and is electrically connected to the first cathode electrode 123 via the sidewall portion 421. Although Fig. 30F illustrates an example in which the second cathode electrode 413 is not in contact with the side surface of the first cathode electrode 123, the second cathode electrode 413 may be in contact with the side surface of the first cathode electrode 123. The sidewall portion 421 may be configured by a material similar to that of the first cathode electrode 123 (for example, a metal oxide such as IZO).

Hereinafter, an example of a method of manufacturing the display device 410 having the above configuration will be described with reference to Figs. 29 A and 30A to 29F.

First, the anode electrode 121 separated for each light emitting element 12 is formed on one main surface of the substrate 11. Next, as illustrated in Fig. 29A, the organic layer 122, the first cathode electrode 123, and the protective layer 412 are sequentially stacked on one main surface of the substrate 11.

Next, as illustrated in Fig. 30A, the protective layer 412 is patterned using, for example, a photolithography technique and an etching technique, and is separated for each light emitting element 12. Next, as illustrated in Fig. 30B, a conductive layer 421A (for example, a metal oxide layer such as an IZO layer) is formed on the first cathode electrode 123, and covers the separated protective layer 412.

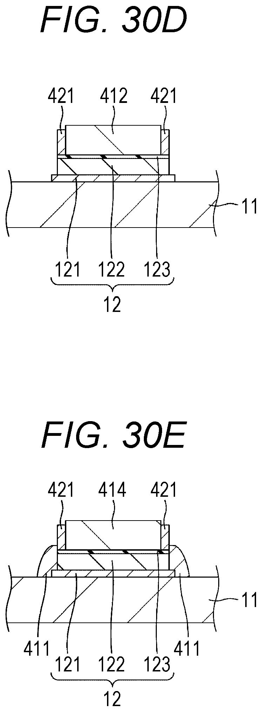

Next, as illustrated in Fig. 30C, the conductive layer 421A is processed by, for example, anisotropic etching so that the conductive layer 421A remains only on the sidewall of the protective layer 412. Next, as illustrated in Fig. 30D, the organic layer 122 and the first cathode electrode 123 are separated for each light emitting element 12. Next, as illustrated in Fig. 30E, after the sidewall 411 covering the side surface of the light emitting element 12 is formed on one main surface of the substrate 11, as illustrated in Fig. 30F, the second cathode electrode 413 is formed on the one main surface of the substrate 11 to cover the light emitting element 12 provided with the protective layer 412, the sidewall portion 421, and the sidewall 411. Therefore, the second cathode electrode 413 and the sidewall portion 421 are connected.

In Modification 1, the second cathode electrode 413 may be connected to either the end portion of the first cathode electrode 123 or the sidewall portion 421 connected to the first cathode electrode 123. That is, an effective connection area between the first cathode electrode 123 and the second cathode electrode 413 can be increased. Thus, even if manufacturing variations occur in the height of the sidewall 411, the film thickness of the first cathode electrode 123, and the like, the first cathode electrode 123 and the second cathode electrode 413 can be stably connected, whereby the yield and reliability can be improved.

### (Modification 2)

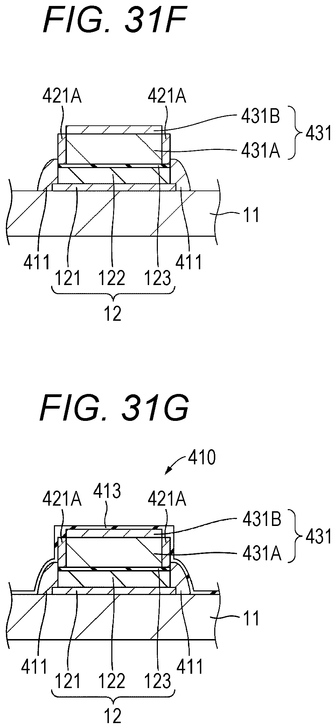

In the second embodiment described above, an example in which the display device 410 includes the protective layer 412 having a single-layer structure has been described. However, as illustrated in Fig. 31G, the display device may include a protective layer 431 having a two-layer structure. The protective layer 431 having a two-layer structure includes a first protective layer 431A and a second protective layer 431B sequentially on the light emitting element 12.

The first protective layer 431A is similar to the protective layer 412 in the second embodiment. The second protective layer 431B is a layer having more etching resistance than the first protective layer 431A. As the material of the second protective layer 431B, for example, a metal oxide such as aluminum oxide can be used.

Here, an example in which the protective layer 412 has a two-layer structure has been described, but the protective layer 412 may have a stacked structure of two or more layers. In this case, the uppermost layer among the two or more layers constituting the protective layer 412 is preferably a layer having more etching resistance than the other layers.

Hereinafter, an example of a method of manufacturing the display device 410 having the above configuration will be described with reference to Figs. 31A to 31G.

First, the anode electrode 121 separated for each light emitting element 12 is formed on one main surface of the substrate 11. Next, as illustrated in Fig. 31A, the organic layer 122, the first cathode electrode 123, the first protective layer 431A, and the second protective layer 431B are sequentially stacked on one main surface of the substrate 11.

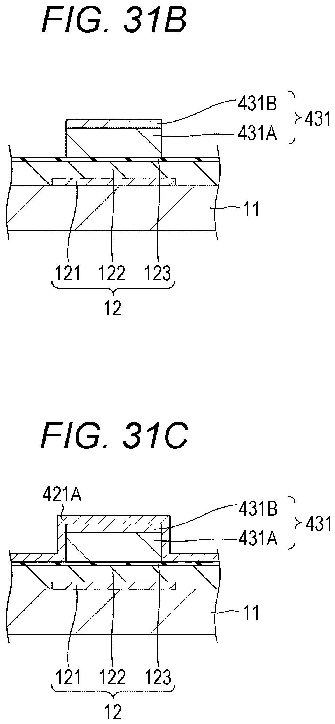

Next, as illustrated in Fig. 31B, the first protective layer 431A and the second protective layer 431B are patterned using, for example, a photolithography technique and an etching technique, and are separated for each light emitting element 12. Therefore, the protective layer 431 having a two-layer structure separated for each light emitting element 12 is formed on the first cathode electrode 123. Next, as illustrated in Fig. 31C, the conductive layer 421A (for example, a metal oxide layer such as an IZO layer) is formed on the first cathode electrode 123, and covers the separated protective layer 431.

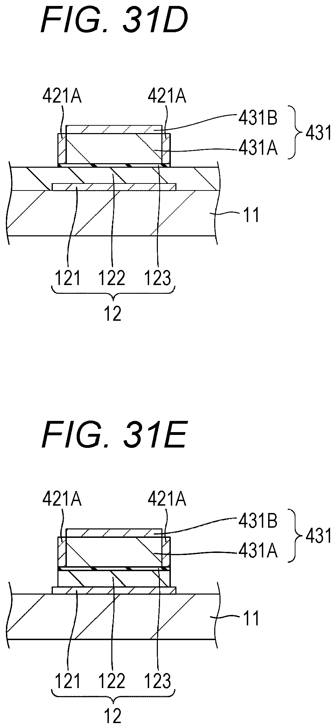

Next, as illustrated in Fig. 31D, the conductive layer 421A is processed by, for example, anisotropic etching so that the conductive layer 421A remains on the sidewall of the protective layer 431. At this time, the conductive layer 421A may be processed such that the conductive layer 421A remains also on the sidewall of the protective layer 431. Next, as illustrated in Fig. 31E, the organic layer 122 and the first cathode electrode 123 are separated for each light emitting element 12.

Next, as illustrated in Fig. 31F, after the sidewall 411 covering the side surface of the light emitting element 12 is formed on one main surface of the substrate 11, as illustrated in Fig. 31G, the second cathode electrode 413 is formed on the one main surface of the substrate 11 to cover the light emitting element 12 provided with the protective layer 431, the sidewall portion 421, and the sidewall 411. Therefore, the second cathode electrode 413 and the sidewall portion 421 are connected.

In Modification 2, the protective layer 431 has a two-layer structure including the first protective layer 431A and the second protective layer 431B in this order, and the constituent material of the second protective layer 431B has higher etching resistance than the constituent material of the first protective layer 431A. Therefore, it is possible to suppress the occurrence of film loss or shape collapse of the protective layer 431 due to exposure to etching during processing of the first cathode electrode 123 or over-etching when the sidewall 411 is formed.

### (Modification 3)

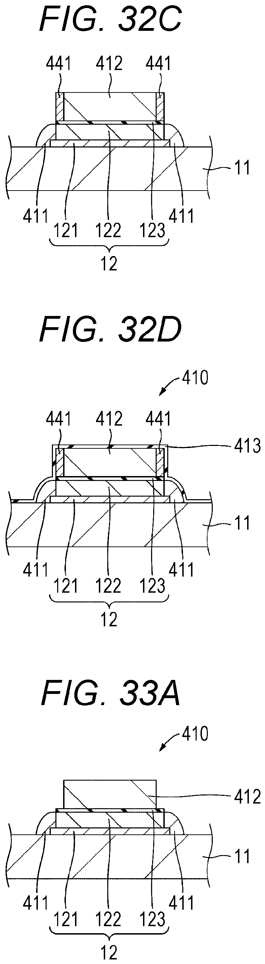

As illustrated in Fig. 32D, the display device 420 may include a sidewall portion 441 that covers a side surface of the protective layer 412. The sidewall portion 441 contains the same type of material as the first cathode electrode 123. The composition ratios of the constituent materials of the sidewall portion 441 and the first cathode electrode 123 may be the same or different.

The sidewall portion 441 may be configured by a depot film. The depot film is a film formed by a deposit of a reaction product on the side surface of the protective layer 412 during dry etching (for example, anisotropic etching).

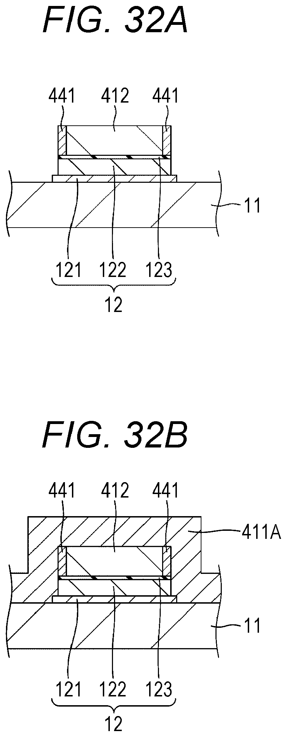

Hereinafter, an example of a method of manufacturing the display device 410 having the above configuration will be described with reference to Figs. 29A and 32A to 32D.

First, the anode electrode 121 separated for each light emitting element 12 is formed on one main surface of the substrate 11. Next, as illustrated in Fig. 29A, the organic layer 122, the first cathode electrode 123, and the protective layer 412 are sequentially stacked on one main surface of the substrate 11.

Next, as illustrated in Fig. 32A, the organic layer 122, the first cathode electrode 123, and the protective layer 412 are processed by, for example, anisotropic etching, and separated for each light emitting element 12. At this time, the conductive deposit containing the constituent elements of the first cathode electrode 123 adheres to the side surface of the protective layer 412 to form the sidewall portion 441. Therefore, a plurality of stacked bodies including the sidewall portion 441, the protective layer 412, and the light emitting element 12 are formed on one main surface of the substrate 11.

Next, as illustrated in Fig. 32B, the insulating layer 411A is formed on one main surface of the substrate 11, and the plurality of stacked bodies is covered with the insulating layer 411A. Next, as illustrated in Fig. 32C, the insulating layer 411A is processed by, for example, anisotropic etching to form the sidewall 411. Next, as illustrated in Fig. 32D, the second cathode electrode 413 is formed on one main surface of the substrate 11 to cover the light emitting element 12 provided with the sidewall portion 441, the protective layer 412, and the sidewall 411. Therefore, the second cathode electrode 413 and the sidewall portion 441 are connected.

In Modification 3, since the second cathode electrode 413 is connected to the sidewall portion 441 configured by the depot film, the similar effect to that of Modification 2 can be obtained. The second cathode electrode 413 may be in contact with the peripheral edge portion of the first cathode electrode 123.

### (Modification 4)

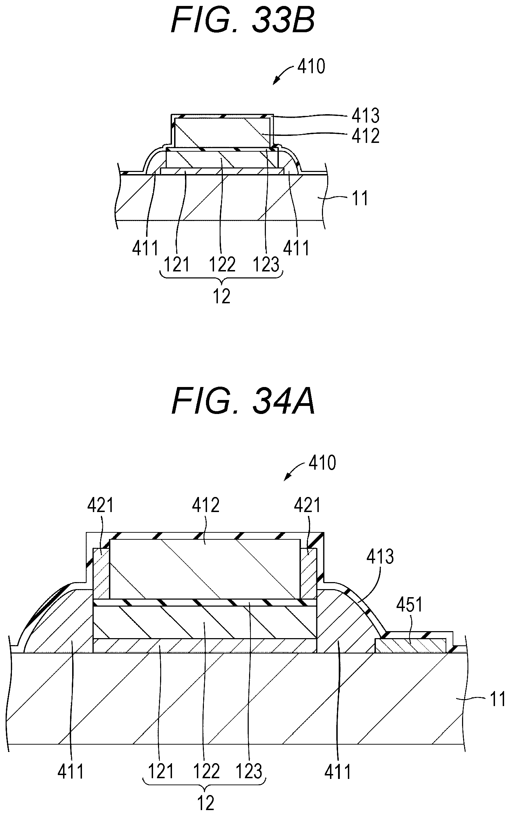

As illustrated in Fig. 33B, the side surface of the protective layer 412 may be located inside the peripheral edge portion of the upper surface of the first cathode electrode 123. The second cathode electrode 413 is in contact with the peripheral edge portion of the upper surface of the first cathode electrode 123 and the side surface of the first cathode electrode 123.

Hereinafter, an example of a method of manufacturing the display device 410 having the above configuration will be described with reference to Figs. 29A to 29C, 33A, and 33B.

First, the steps from the formation of the anode electrode 121 to the formation of the insulating layer 411A are performed in the similar manner to the method of manufacturing the display device 410 according to the second embodiment (see Figs. 29A to 29C).

Next, as illustrated in Fig. 33A, the insulating layer 411A is processed by, for example, anisotropic etching to form the sidewall 411, and the side surface of the protective layer 412 is retracted from the peripheral edge portion of the upper surface of the first cathode electrode 123.

For example, the sidewall 411 and the protective layer 412 are configured by the same material (for example, SiN), and further a dry etching condition under which the first cathode electrode 123 (for example, IZO layer) is difficult to process is selected, so that the side surface of the protective layer 412 can be retracted from the peripheral edge portion of the one main surface of the first cathode electrode 123.

Next, as illustrated in Fig. 33B, the second cathode electrode 413 is formed on one main surface of the substrate 11 to cover the light emitting element 12 provided with the protective layer 412 and the sidewall 411. Therefore, the second cathode electrode 413 is brought into contact with the peripheral edge portion of the upper surface of the first cathode electrode 123 and the side surface of the first cathode electrode 123.

In Modification 4, an effective connection area between the first cathode electrode 123 and the second cathode electrode 413 can be increased. Thus, even if manufacturing variations occur in the height of the sidewall 411, the film thickness of the first cathode electrode 123, and the like, the first cathode electrode 123 and the second cathode electrode 413 can be stably connected. Accordingly, yield and reliability can be improved.

### (Modification 5)

The display device 410 may further include a contact portion 451 as illustrated in Fig. 34A. The contact portion 451 is an auxiliary electrode that connects the second cathode electrode 413 and an underlying wire (not illustrated). The upper surface of the contact portion 451 is connected to the peripheral edge portion of the second cathode electrode 413. On the other hand, the lower surface of the contact portion 451 is connected to the underlying wire via a contact plug (not illustrated). In the present specification, the peripheral edge portion of the second cathode electrode 413 refers to a region having a predetermined width from the peripheral edge of the second cathode electrode 413 toward the inside.

The contact portion 451 is provided in a peripheral region on one main surface of the substrate 11. The contact portion 451 has a rectangular closed loop shape surrounding the display region. The contact portion 451 may be configured by the same layer as the anode electrode 121. The contact portion 451 may be provided at the same height as the anode electrode 121.

The end portion of the sidewall 411 may be placed on the contact portion 451. In this case, it is possible to suppress disconnection of the second cathode electrode 413 due to the step of the contact portion 451, and thus, it is possible to suppress an increase in resistance of the second cathode electrode 413 in the vicinity of the connecting portion between the second cathode electrode 413 and the contact portion 451.

For example, the end portion of the sidewall 411 can be placed on the contact portion 451 as described above by controlling the film thickness of the insulating layer 411A for forming the sidewall 411 and dry etching conditions such as gas and pressure when forming the insulating layer 411A.

### (Modification 6)

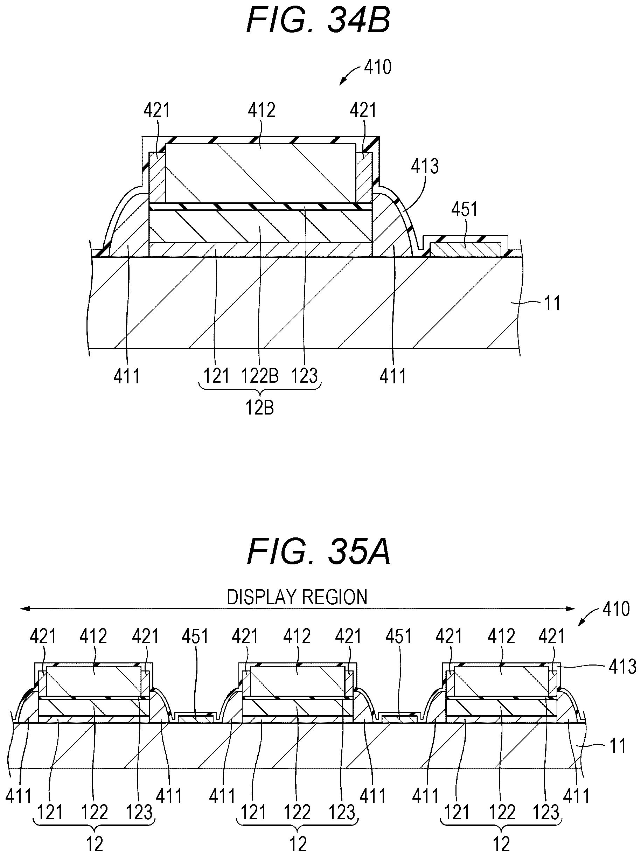

In Modification 5, an example in which the end portion of the sidewall 411 is placed on the contact portion 451 has been described. However, as illustrated in Fig. 34B, the end portion of the sidewall 411 may be separated from the contact portion 451 such that the end portion of the sidewall 411 is not placed on the contact portion 451. In this case, it is possible to suppress light emitted from the organic layer 122 from propagating inside the sidewall 411 and being reflected by the contact portion 451. Thus, deterioration in display quality can be suppressed.

### (Modification 7)

The contact portion 451 may be provided in the display region as illustrated in Fig. 35A. For example, the contact portion 451 may be provided between the adjacent light emitting elements 12. In the display region, the contact portion 451 is connected to a drive circuit and the like via a contact plug (not illustrated), for example. Since the contact portion 451 is provided in the display region as described above, the resistance of the second cathode electrode 413 can be reduced.

### (Modification 8)

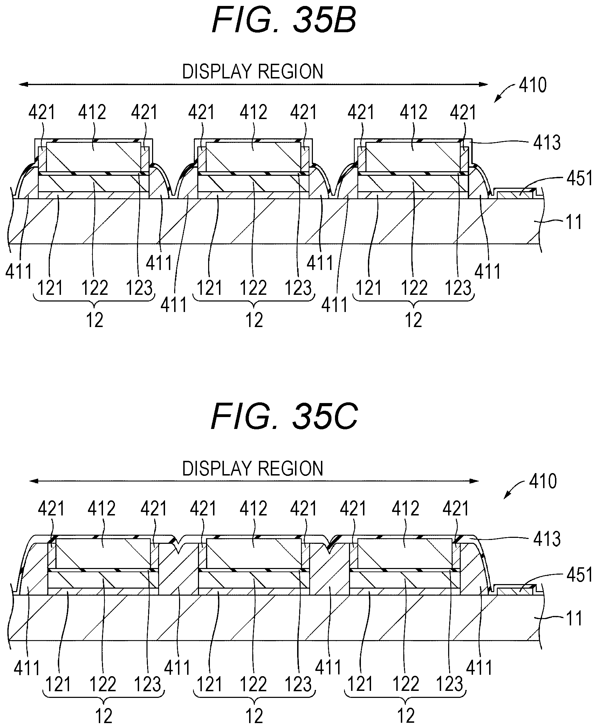

The contact portion 451 may be provided outside the display region as illustrated in Fig. 35B. Since the contact portion 451 is provided outside the display region in this manner, the size of the light emitting element 12 can be increased.

In a case where the contact portion 451 is provided outside the display region, as illustrated in Fig. 35C, a space between the separated light emitting elements 12 may be filled with the sidewall 411 as an insulating layer.

In the case of the above configuration illustrated in Fig. 35B, there is a possibility that the net distance from each light emitting element 12 to the contact portion 451 increases in a recess between the adjacent light emitting elements 12. On the other hand, in the case of the above configuration illustrated in Fig. 35C, since the recess between the adjacent light emitting elements 12 can be reduced, an increase in the net distance from each light emitting element 12 to the contact portion 451 can be suppressed. Thus, in the case of the above configuration illustrated in Fig. 35C, an increase in the resistance of the second cathode electrode 413 can be suppressed.

### (Modification 9)

In Modifications 5 to 8, an example in which the second anode electrode 413 is connected to the contact portion 451 has been described, but the second anode electrode 413 may be connected to a wiring layer 461 provided in the substrate 11.

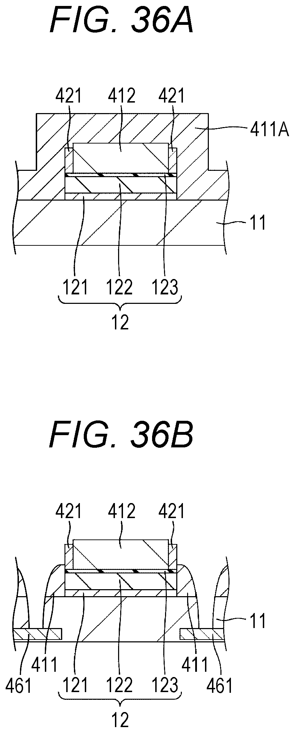

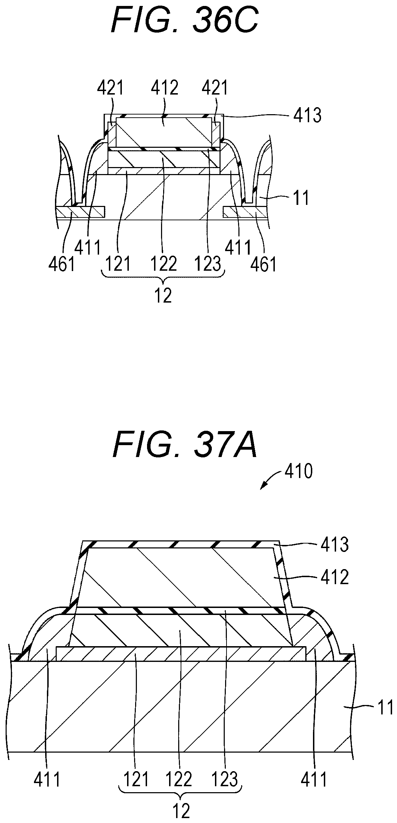

The display device 410 having the above connection configuration can be manufactured, for example, as follows. First, as illustrated in Fig. 36A, the protective layer 412 separated for each light emitting element 12 is covered with the insulating layer 411A, and then, as illustrated in Fig. 36B, anisotropic etching for forming the sidewall 411 is performed until reaching the wiring layer 461 in the substrate 11. Next, the second cathode electrode 413 is formed on the substrate 11. Therefore, the second cathode electrode 413 is connected to the wiring layer 461.

### (Modification 10)

In the second embodiment, an example in which the side surfaces of the organic layer 122, the first cathode electrode 123, and the protective layer 412 are vertical surfaces has been described, but as illustrated in Fig. 37A, the side surfaces of the organic layer 122, the first cathode electrode 123, and the protective layer 412 may be inclined surfaces. In this case, since the second cathode electrode 413 covering the side surfaces of the organic layer 122, the first cathode electrode 123, and the protective layer 412 can be formed thick, the resistance of the second cathode electrode 413 can be reduced.

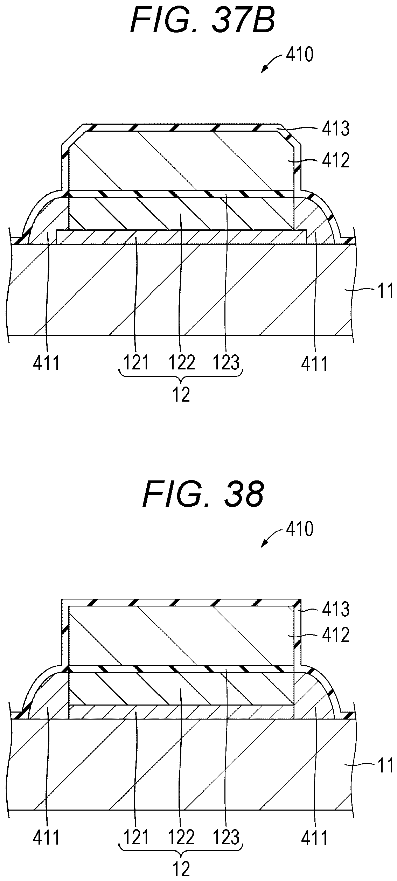

As illustrated in Fig. 37B, the protective layer 412 may be rounded between the side surface and the upper surface. Also in this case, in this case, the second cathode electrode 413 covering the side surface of the protective layer 412 can be formed thick.

### (Modification 11)

In the second embodiment, an example has been described in which the anode electrode 121, the organic layer 122, and the first cathode electrode 123 are separately processed by lithography and etching to form a pattern. However, after the anode electrode 121, the organic layer 122, and the first cathode electrode 123 are stacked, the anode electrode 121, the organic layer 122, and the first cathode electrode 123 may be etched and separated at once. In this case, the size of the anode electrode 121 does not need to be larger than the sizes of the organic layer 122 and the first cathode electrode 123 in consideration of the superposition misalignment. That is, as illustrated in Fig. 38, the anode electrode 121, the organic layer 122, and the first cathode electrode 123 can have the same size. Thus, the light emitting region can be enlarged.

### (Modification 12)

The refractive index of the sidewall 411 may be lower than the refractive index of the organic layer 122. Since the light emitted from the organic layer 122 can be totally reflected at the interface between the organic layer 122 and the sidewall 411, the light emitted from the organic layer 122 can be suppressed from propagating in the lateral direction, and the luminance on the front side can be efficiently increased.

### < 3 Third embodiment >

### [3.1 Configuration of display device]

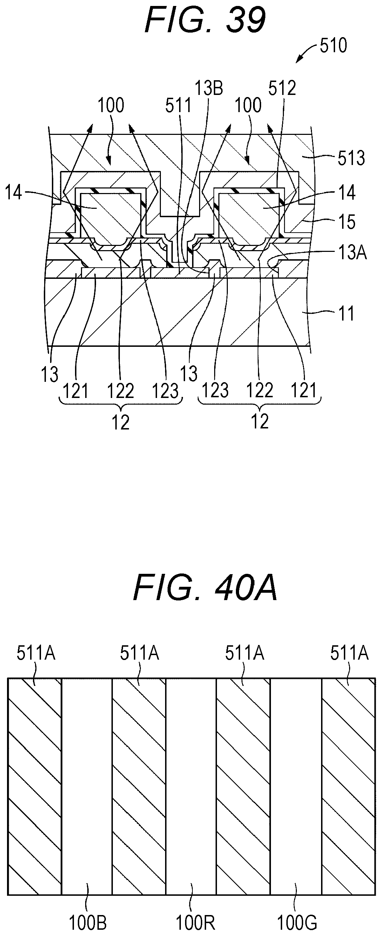

Fig. 39 is a cross-sectional view illustrating an example of a configuration of a display device 510 according to a third embodiment of the present disclosure. The display device 510 includes a substrate 11 having one main surface, a plurality of light emitting elements 12 and a contact portion 511 provided on the one main surface of the substrate 11, a protective layer 14 covering the plurality of light emitting elements 12, a second cathode electrode 512 covering the protective layer 14, the contact portion 511, and the like, a protective layer 15 covering the second cathode electrode 512, and a resin layer 513 covering the protective layer 15.

### (Insulating layer)

The insulating layer 13 has an opening 13A in a portion corresponding to each anode electrode 121, and covers from the peripheral edge portion of the upper surface of the anode electrode 121 to the side surface (end surface) of the anode electrode 121. Here, the peripheral edge portion of the upper surface of the anode electrode 121 refers to a region having a predetermined width from the peripheral edge of the upper surface of the anode electrode 121 toward the inside. The light emitting element 12 is separated outside the opening 13A of the insulating layer 13.

Furthermore, the insulating layer 13 also has an opening 13B in a portion corresponding to the contact portion 511, and covers from the peripheral edge portion of the upper surface of the contact portion 511 to the side surface (end surface) of the contact portion 511. Here, the peripheral edge portion of the upper surface of the contact portion 511 refers to a region having a predetermined width from the peripheral edge of the upper surface of the contact portion 511 toward the inside.

### (Contact portion)

The contact portion 511 is provided between the adjacent light emitting elements 12. The contact portion 511 may be configured by the same layer as the anode electrode 121. The contact portion 511 is connected to an underlying wire (not illustrated) via a contact plug (not illustrated).

### (Second cathode electrode)

The second cathode electrode 512 is provided as an electrode common to all the light emitting elements 12 in the display region. The second cathode electrode 512 covers the upper surface and the side surface of the protective layer 14 separated for each light emitting element 12, and covers the peripheral edge portion (hereinafter, referred to as "terrace portion") of the upper surface of the light emitting element 12 and the side surface of the light emitting element 12. The second cathode electrode 124 is connected to the peripheral edge portion of the upper surface of the first cathode electrode 123 at the peripheral edge portion of the upper surface of the light emitting element 12. Furthermore, the second cathode electrode 124 covers a portion between the adjacent light emitting elements 12, and is connected to the contact portion 511 at this portion.

Here, the peripheral edge portion of the upper surface of the light emitting element 12 refers to a region having a predetermined width from the peripheral edge of the upper surface of the light emitting element 12 toward the inside. Furthermore, the peripheral edge portion of the upper surface of the first cathode electrode 123 refers to a region having a predetermined width from the peripheral edge of the upper surface of the first cathode electrode 123 toward the inside.

### (Resin layer)

The resin layer 513 covers the protective layer 15. The resin layer 513 fills the recess between the light emitting elements 12. The resin layer 513 is preferably a low refractive resin having a lower refractive index than the protective layer 15. Therefore, the display device 510 can have a waveguide structure, so that the light extraction efficiency of the front surface can be improved. In a case where the display device 510 has a waveguide structure, the protective layer 15 is preferably configured by a material such as silicon nitride (SiN) having a high refractive index.

### (Pixel array)

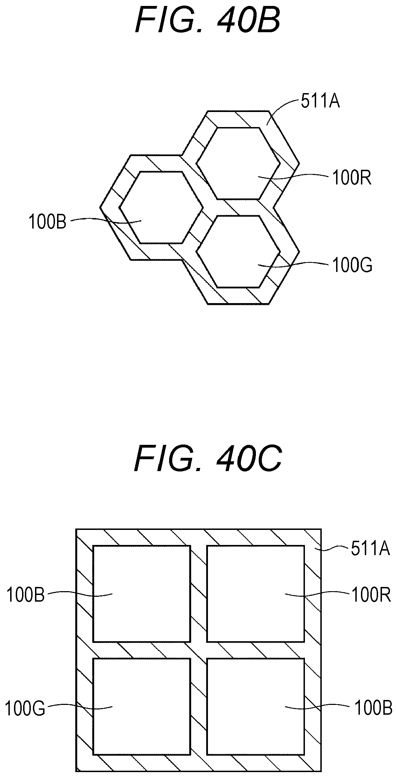

The arrangement of the plurality of images 100R, 100G, and 100B is, for example, a strip array (see Fig. 40A), a delta array (see Fig. 40B), or a square array (see Fig. 40C). A cathode contact region 511A is provided between the pixel 100 and the pixel 100. Here, the cathode contact region 511A is a region including a terrace portion of the adjacent light emitting element 12 and a portion located between the terraces.

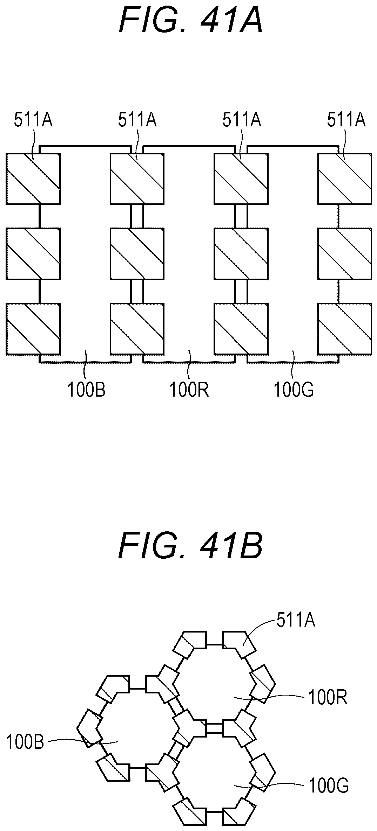

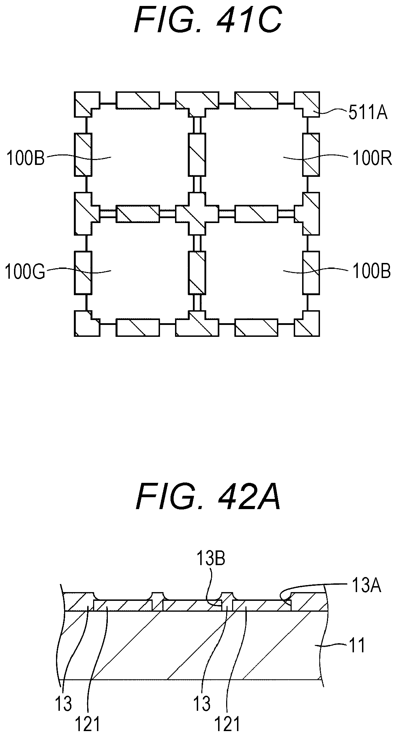

The cathode contact region 511A may be continuously provided between the pixel 100 and the pixel 100 as illustrated in Figs. 40A, 40B, and 40C, or may be intermittently provided between the pixel 100 and the pixel 100 as illustrated in Figs. 41A, 41B, and 41C.

### [3.2 Method of manufacturing display device]

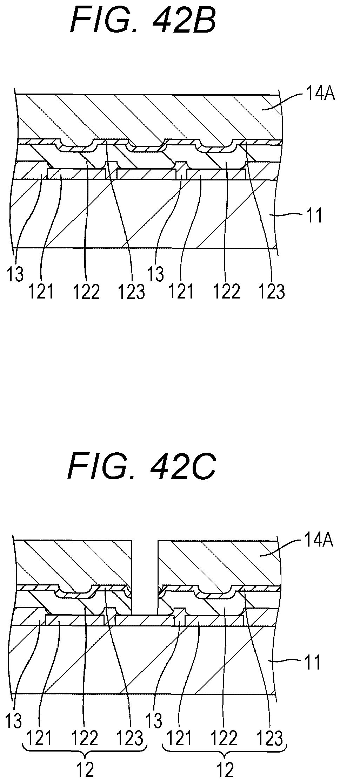

Hereinafter, an example of a method of manufacturing the display device 510 having the above configuration will be described with reference to Figs. 42A to 42F.

First, the anode electrode 121 is formed by, for example, a sputtering method, and then the anode electrode 121 is processed by, for example, photolithography and dry etching. As a material of the anode electrode 121, an AL alloy, an Ag alloy, or the like may be used. Furthermore, as the material of the anode electrode 121, a material having a high work function and high transmittance such as ITO or IGZO may be used. Next, the insulating layer 13 is formed on one main surface of the substrate 11 by a CVD method. Thereafter, as illustrated in Fig. 42A, the opening 13A and the opening 13B are formed using, for example, a resist mask and dry etching.

Next, the organic layer 122 is formed on the anode electrode 121 by, for example, a vapor deposition method. As the organic layer 122, a layer having a high hole transport property such as a hole injection layer (HIL) or a hole transfer layer (HTL) may be used. Next, the first cathode electrode 121 and the first protective layer 14A are sequentially stacked on the organic layer 122. As the first cathode electrode 123, a material having a high work function and high transmittance such as IZO or ITO may be used, or a MgAg alloy or the like may be used from the viewpoint of device characteristics. The first protective layer 14A is preferably a layer that can be formed at a low temperature of 100°C or lower and has a high sealing property against moisture and oxygen.

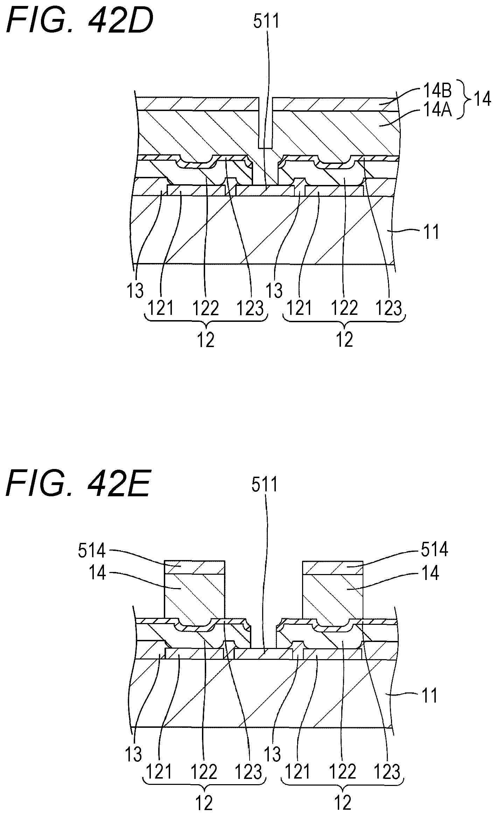

Next, as illustrated in Fig. 42C, the organic layer 122, the first cathode electrode 123, and the first protective layer 14A are processed using, for example, photolithography and dry etching to separate the pixels 100. Next, as illustrated in Fig. 42D, the second protective layer 14B is formed on the first protective layer 14A. Therefore, the protective layer 14 having a two-layer structure is obtained. The film formation conditions of the second protective layer 14B may be similar to the film formation conditions of the first protective layer 14A.

Next, as illustrated in Fig. 42E, after a resist layer 514 of a prescribed pattern is formed on the protective layer 14, the second protective layer 14B is processed using, for example, dry etching to separate the pixels 100 and expose the contact portion 511. Since the protective layer 14 is provided on the light emitting region, plasma damage to the light emitting region can be suppressed. Thereafter, the resist layer 514 is removed by low-temperature ashing at 100°C or lower, for example. When wet etching is used, there is a concern that the organic layer 122 may be peeled off, and therefore dry etching is preferably used.

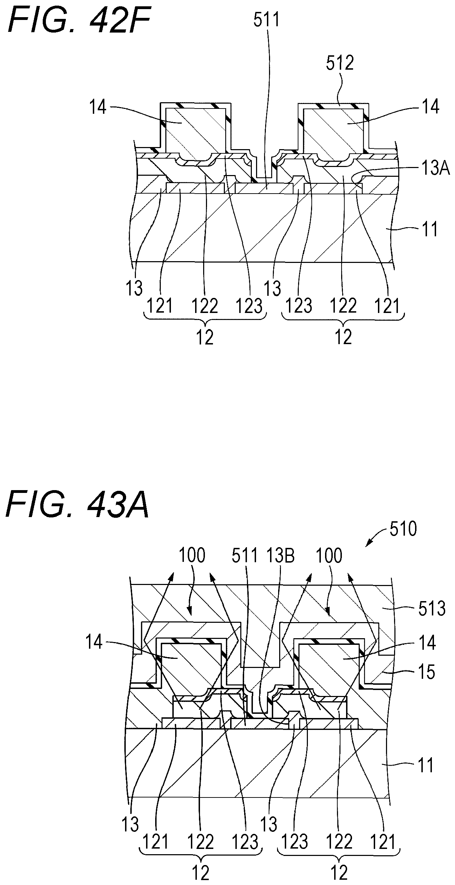

Next, as illustrated in Fig. 42F, the second cathode electrode 512 is formed as a common cathode in the entire display region by, for example, a sputtering method. As the material of the second cathode electrode 512, the similar material to that of the first cathode electrode 123 may be used. Next, as illustrated in Fig. 39, after the second cathode electrode 512 is covered with the protective layer 15, the resin layer 513 is formed on the protective layer 15. At this time, the recess between the pixels 100 is filled with the resin layer 513.

### [3.3 Operational effect]

In the display device 510 according to the second embodiment, since the light emitting element 12 is separated outside the opening 13A of the insulating layer 13, plasma damage caused by dry etching can be suppressed from being applied in the light emitting region. Furthermore, when the cathode contact region 511A is formed, it is also possible to suppress plasma damage caused by dry etching in the light emitting region.

Since the entire light emitting region is covered with the protective layer 14 and the protective layer 15, formation of a leakage path of moisture or the like can be suppressed.

Since a backing wiring is formed via the contact portion 511, the influence of the cathode resistance can be reduced.

Since the second cathode electrode 512 is connected to the first cathode electrode 123 in the terrace portion, the cathode resistance can be reduced.

Since the contact portion 511 is arranged in the display region, the cathode contact may not be arranged outside the display region. Furthermore, since the distance from the contact portion 511 to the light emitting element 12 (pixel 100) becomes short, the occurrence of IR drop can be suppressed.

In the future, it is predicted that the spread of the organic EL coating structure will advance from the viewpoint of luminance and light emission efficiency. In the conventional structure, device characteristic degradation due to processing damage becomes remarkable, but by using the present technology, it is possible to provide a device to meet the needs such as shading and panel miniaturization as well as preventing device characteristic degradation in advance.

### [3.4 Modifications]

### (Modification 1)

As illustrated in Fig. 43A, there may be a region where the contact portion 511 is not provided between the light emitting elements 12 in the display region. The insulating layer 13 may not be provided on the substrate 11 in this region and may be covered with the protective layer 14. In this case, occurrence of the leakage between pixels caused by the insulating layer 13 can be suppressed.

### (Modification 2)

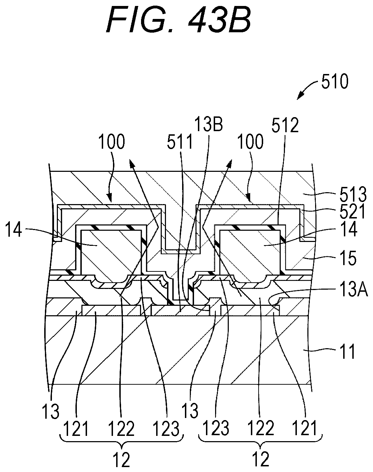

As illustrated in Fig. 43B, a protective layer 521 may be further provided on the protective layer 15. The protective layer 521 is an ALD layer configured by alumina (aluminum oxide) or the like. By adopting such a configuration, the sealing performance by the protective layers 14, 15, and 521 can be improved, and the reliability of the display device 510 can be improved.

### < 4 Applications >

### (Electronic apparatus)

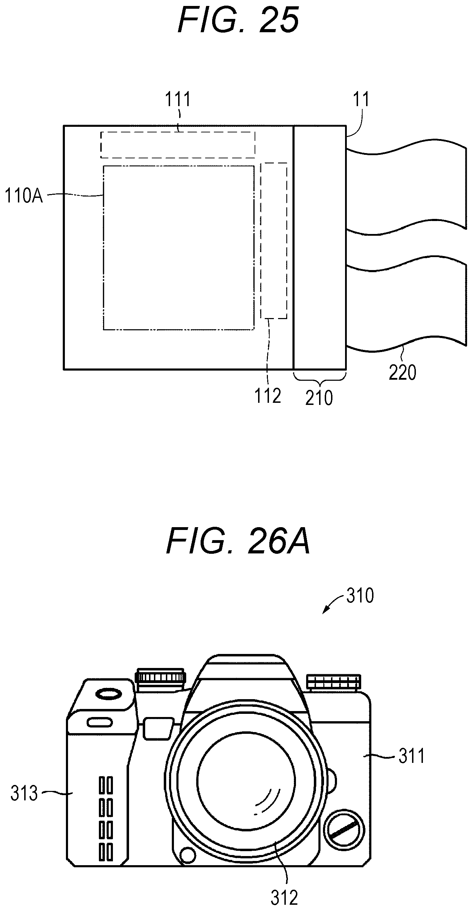

The display device 10 according to any one of the first to third embodiments and the modifications thereof described above is incorporated in various electronic apparatuses as a module as illustrated in Fig. 25, for example. In particular, high resolution such as an electronic viewfinder or a head-mounted display of a video camera or a single-lens reflex camera is required, and is suitable for those that are enlarged and used near eyes. This module has a region 210 exposed without being covered with a counter substrate or the like on one short side of the substrate 11, and external connection terminals (not illustrated) are formed in this region 210 by extending the wirings of the signal line drive circuit 111 and the scanning line drive circuit 112. A flexible printed circuit (FPC) 220 for inputting and outputting signals may be connected to the external connection terminal.

### (Specific example 1)

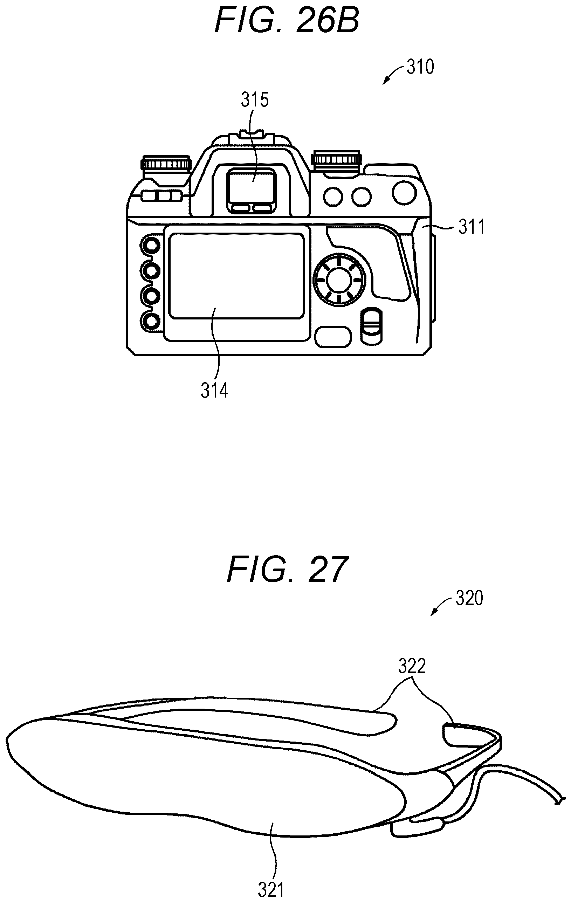

Figs. 26A and 26B illustrate an example of an external appearance of a digital still camera 310. The digital still camera 310 is of a lens interchangeable single lens reflex type, and includes an interchangeable imaging lens unit (interchangeable lens) 312 substantially at the center in front of a camera body portion (camera body) 311, and a grip portion 313 to be held by a photographer on the front left side.

A monitor 314 is provided at a position shifted to the left from the center of the back surface of the camera body portion 311. An electronic viewfinder (eyepiece window) 315 is provided above the monitor 314. By looking into the electronic viewfinder 315, the photographer can determine the composition by visually recognizing the optical image of the subject guided from the imaging lens unit 312. As the electronic viewfinder 315, the display device 10 according to any one of the first to third embodiments or the modifications thereof described above can be used.

### (Specific example 2)

Fig. 27 illustrates an example of an external appearance of a head mounted display 320. The head mounted display 320 includes, for example, ear hooking portions 322 to be worn on the head of the user on both sides of the glass-shaped display unit 321. As the display unit 321, the display device 10 according to any one of the first to third embodiments or the modifications thereof described above can be used.

### (Specific example 3)

Fig. 28 illustrates an example of an external appearance of a television device 330. The television device 330 includes, for example, an image display screen unit 331 including a front panel 332 and a filter glass 333, and the image display screen unit 331 is configured by the display device 10 according to any one of the first to third embodiments or the modifications thereof described above.

Although the first to third embodiments and modifications of the present disclosure have been specifically described above, the present disclosure is not limited to the first to third embodiments and the modifications described above, and various modifications based on the technical idea of the present disclosure can be made.

For example, the configurations, methods, steps, shapes, materials, numerical values, and the like described in the first to third embodiments and the modifications described above are merely examples, and different configurations, methods, steps, shapes, materials, numerical values, and the like may be used as necessary.

The configurations, methods, steps, shapes, materials, numerical values, and the like of the first to third embodiments and the modifications described above can be combined with each other without departing from the gist of the present disclosure.

The materials exemplified in the first to third embodiments and the modifications described above can be used alone or in combination of two or more unless otherwise specified.

Furthermore, the present disclosure can adopt the following configurations.
(1)
   A display device including:
   a plurality of light emitting elements including an anode electrode, an organic light emitting layer, and a first cathode electrode, the anode electrode, the organic light emitting layer, and the first cathode electrode being separated for each sub-pixel;
   a protective layer configured to cover the plurality of light emitting elements; and
   a second cathode electrode provided on the protective layer, in which
   the second cathode electrode is connected to each of the separated first cathode electrodes.
(2) The display device according to (1), in which
   the protective layer has a plurality of contact holes, and
   the second cathode electrode is configured to be connected to each of the separated first cathode electrodes via the contact hole.
(3) The display device according to (1) or (2), in which
   the first cathode electrode and the second cathode electrode each independently contain a transparent metal oxide, metal, or alloy.
(4) The display device according to any one of (1) to (3), in which
   the first cathode electrode contains a transparent metal oxide, and
   the second cathode electrode contains a metal or an alloy.
(5) The display device according to any one of (1) to (4), in which
   the protective layer contains at least one of an inorganic oxide and an organic insulating material.
(6) The display device according to any one of (1) to (5), in which
   the protective layer is a multilayer film.
(7) The display device according to any one of (1) to (6), in which
   a plurality of the sub-pixels includes a plurality of red sub-pixels, a plurality of green sub-pixels, and a plurality of blue sub-pixels, and
   a thickness of the protective layer on the separated first cathode electrode is substantially a same in the red sub-pixel, the green sub-pixel, and the blue sub-pixel.
(8) The display device according to any one of (1) to (6), in which
   the sub-pixel is provided with a resonator structure that causes light generated in the organic light emitting layer to resonate,
   a plurality of the sub-pixels include a plurality of red sub-pixels, a plurality of green sub-pixels, and a plurality of blue sub-pixels, and
   a thickness of the protective layer on the separated first cathode electrode is different for each of the red sub-pixel, the green sub-pixel, and the blue sub-pixel.
(9) The display device according to any one of (1) to (8), in which
   the first cathode electrode and the second cathode electrode are connected outside a light emitting region of the sub-pixel.
(10) The display device according to any one of (1) to (9), in which
   the number of connecting portions between the first cathode electrode and the second cathode electrode is one or two or more for one sub-pixel.
(11) The display device according to any one of (1) to (9), in which
   the second cathode electrode includes a plurality of contact portions, and
   one of the contact portions is connected to two or more of the sub-pixels.
(12) The display device according to any one of (1) to (11), in which
   a connecting portion between the first cathode electrode and the second cathode electrode has a dotted or linear shape.
(13) The display device according to any one of (1) to (12), in which
   the first cathode electrode has a facing surface that faces the second cathode electrode, and
   a connecting portion between the first cathode electrode and the second cathode electrode is provided along a peripheral edge of the facing surface.
(14) The display device according to any one of (1) to (11 in which
   the second cathode electrode is connected to an end portion of the first cathode electrode.
(15) The display device according to any one of (1) to (12), in which
   the first cathode electrode has a protruding portion that protrudes with respect to a peripheral edge of a light emitting region of the light emitting element, and
   the second cathode electrode is connected to the first cathode electrode at the protruding portion.
(16) The display device according to any one of (1) to (12), in which
   the light emitting element has a cutout portion at a peripheral edge of a light emitting region of the light emitting element, and
   the second cathode electrode is connected to the first cathode electrode in the cutout portion.
(17) The display device according to any one of (1) to (16), in which
   the protective layer has a plurality of air gaps, and
   each of the plurality of air gaps is provided between the sub-pixels that are adjacent to each other.
(18) The display device according to claim 1, further including:
   a protective layer configured to cover the second cathode electrode.
(19) A display device including:
   a plurality of light emitting elements including a first electrode, an organic light emitting layer, and a second electrode, the second electrode, the organic light emitting layer, and the second electrode being separated for each sub-pixel;
   a protective layer configured to cover the plurality of light emitting elements; and
   a third electrode provided on the protective layer, in which
   the third electrode is connected to each of the separated second electrodes.
(20) An electronic apparatus including:
   a display device according to any one of (1) to (19) .

### REFERENCE SIGNS LIST

- 10: display device
- 11: substrate
- 12R, 12B, 12G, 12W: light emitting element
- 13: insulating layer
- 14, 15: protective layer
- 14A, 15A: first protective layer
- 14B, 15B: second protective layer
- 14C: air gap
- 14H: contact hole
- 16: color filter
- 16R: red filter
- 16G: green filter
- 16B: blue filter
- 17R, 17G, 17B: resonator structure
- 100R, 100G, 100B: sub-pixel
- 101: light emitting region
- 102: protruding portion
- 103: cutout portion
- 110A: display region
- 110B: peripheral region
- 111: signal line drive circuit
- 111A: signal line
- 112: scanning line drive circuit
- 112A: scanning line
- 121: anode electrode
- 122: organic layer
- 122K: hole injection layer
- 122L: hole transport layer
- 122M: organic light emitting layer
- 122N: Electron transport layer
- 123: first cathode electrode
- 123A: protruding portion
- 124: second cathode electrode
- 124A: contact portion
- 124B: connecting portion
- 124C: shared connecting portion
- 310: digital still camera (electronic apparatus)
- 320: head mounted display (electronic apparatus)
- 330: television device (electronic apparatus)

## Claims

1. A display device comprising:
a plurality of light emitting elements including an anode electrode, an organic light emitting layer, and a first cathode electrode, the anode electrode, the organic light emitting layer, and the first cathode electrode being separated for each sub-pixel;
a protective layer configured to cover the plurality of light emitting elements; and
a second cathode electrode provided on the protective layer, wherein
the second cathode electrode is connected to each of the separated first cathode electrodes.

2. The display device according to claim 1, wherein
the protective layer has a plurality of contact holes, and
the second cathode electrode is configured to be connected to each of the separated first cathode electrodes via the contact hole.

3. The display device according to claim 1, wherein
the first cathode electrode and the second cathode electrode each independently contain a transparent metal oxide, metal, or alloy.

4. The display device according to claim 1, wherein
the first cathode electrode contains a transparent metal oxide, and
the second cathode electrode contains a metal or an alloy.

5. The display device according to claim 1, wherein
the protective layer contains at least one of an inorganic oxide and an organic insulating material.

6. The display device according to claim 1, wherein the protective layer is a multilayer film.

7. The display device according to claim 1, wherein
a plurality of the sub-pixels includes a plurality of red sub-pixels, a plurality of green sub-pixels, and a plurality of blue sub-pixels, and
a thickness of the protective layer on the separated first cathode electrode is substantially a same in the red sub-pixel, the green sub-pixel, and the blue sub-pixel.

8. The display device according to claim 1, wherein
the sub-pixel is provided with a resonator structure that causes light generated in the organic light emitting layer to resonate,
a plurality of the sub-pixels include a plurality of red sub-pixels, a plurality of green sub-pixels, and a plurality of blue sub-pixels, and
a thickness of the protective layer on the separated first cathode electrode is different for each of the red sub-pixel, the green sub-pixel, and the blue sub-pixel.

9. The display device according to claim 1, wherein
the first cathode electrode and the second cathode electrode are connected outside a light emitting region of the sub-pixel.

10. The display device according to claim 1, wherein
the number of connecting portions between the first cathode electrode and the second cathode electrode is one or two or more for one sub-pixel.

11. The display device according to claim 1, wherein
the second cathode electrode includes a plurality of contact portions, and
one of the contact portions is connected to two or more of the sub-pixels.

12. The display device according to claim 1, wherein
a connecting portion between the first cathode electrode and the second cathode electrode has a dotted or linear shape.

13. The display device according to claim 1, wherein
the first cathode electrode has a facing surface that faces the second cathode electrode, and
a connecting portion between the first cathode electrode and the second cathode electrode is provided along a peripheral edge of the facing surface.

14. The display device according to claim 1, wherein
the second cathode electrode is connected to an end portion of the first cathode electrode.

15. The display device according to claim 1, wherein
the first cathode electrode has a protruding portion that protrudes with respect to a peripheral edge of a light emitting region of the light emitting element, and
the second cathode electrode is connected to the first cathode electrode at the protruding portion.

16. The display device according to claim 1, wherein
the light emitting element has a cutout portion at a peripheral edge of a light emitting region of the light emitting element, and
the second cathode electrode is connected to the first cathode electrode in the cutout portion.

17. The display device according to claim 1, wherein
the protective layer has a plurality of air gaps, and
each of the plurality of air gaps is provided between the sub-pixels that are adjacent to each other.

18. The display device according to claim 1, further comprising:
a protective layer configured to cover the second cathode electrode.

19. A display device comprising:
a plurality of light emitting elements including a first electrode, an organic light emitting layer, and a second electrode, the second electrode, the organic light emitting layer, and the second electrode being separated for each sub-pixel;
a protective layer configured to cover the plurality of light emitting elements; and
a third electrode provided on the protective layer, wherein
the third electrode is connected to each of the separated second electrodes.

20. An electronic apparatus comprising:
a display device according to claim 1.
